# FASCICULE DE BREVET EUROPEEN

(11) **EP 4 268 281 B1**
(45) Date de publication et mention de la délivrance du brevet: **26.02.2025**
(21) Numéro de dépôt: 21844246.5
(22) Date de dépôt: 21.12.2021
(51) Int. Cl.: H01L 27/146, H01L 31/02, H01L 31/09, H01L 31/0224

(54) **INTÉGRATION D'UN CIRCUIT DE DÉTECTION À BASE DE RÉSONATEURS OPTIQUES INTERCONNECTÉS SUR UN CIRCUIT DE LECTURE D'UN IMAGEUR**
INTEGRATION EINER DETEKTIONSSCHALTUNG AUF DER BASIS VON OPTISCHEN RESONATOREN, DIE MIT EINER AUSLESESCHALTUNG EINES BILDAUFNEHMERS VERBUNDEN SIND
INTEGRATION OF A DETECTION CIRCUIT BASED ON OPTICAL RESONATORS INTERCONNECTED ON A READOUT CIRCUIT OF AN IMAGER

(30) Priorité: 23.12.2020 FR 2014012
(43) Date de publication de la demande: 01.11.2023
(73) Titulaire: THALES, 92190 Meudon (FR); Commissariat à l'Energie Atomique et aux Energies Alternatives, 75015 Paris (FR)
(72) Inventeur: DELGA, Alexandre, 91477 Palaiseau Cedex (FR); ESPIAU DE LAMAESTRE, Roch, 38000 Grenoble (FR)
(74) Mandataire: Atout PI Laplace
(86) Numéro de dépôt international: PCT/EP2021/087001
(87) Numéro de publication internationale: WO 2022/136376

(56) Documents cités:
- EP-A1- 3 084 843
- EP-B1- 3 084 843
- EP-B1- 3 662 512
- WO-A1-2019/025342
- US-A1- 2011 156 194

## Description

### Champ d'application

L'invention concerne les systèmes hybrides, c'est à dire constitués de deux parties distinctes assemblées par une couche d'assemblage, chaque partie étant réalisée dans un matériau différent. Ces systèmes peuvent être optiques, électroniques ou optoélectroniques en fonction des caractéristiques des parties assemblées. L'invention concerne particulièrement l'intégration d'une pluralité de résonateurs optiques de type métal-isolant-métal sur un circuit intégré de lecture d'un capteur d'image matriciel dans le domaine de l'infrarouge. L'imageur matriciel est composé d'une pluralité de pixels, et chaque pixel comprend une pluralité de résonateurs optiques interconnectés.

### Problème soulevé

Les systèmes hybrides permettent d'associer deux fonctionnalités réalisées dans des matériaux différents. Il s'agit par exemple :
- d'un détecteur, dans lequel la partie sensible est associée à un circuit de lecture permettant de récolter et traiter le signal à détecter,
- d'un afficheur, par exemple de type électroluminescent, dans lequel la partie émettrice est associée avec un circuit de génération de signaux électriques adaptés à l'émission,
- d'un circuit photonique, avec des émetteurs lasers associés à des couches de traitement des faisceaux émis (guidage, multiplexage/démultiplexage, amplification ...), la/les couches de traitement étant déposées sur un substrat silicium (« Photonic on Silicon »),
- d'un circuit électronique avec des transistors rapides ou de puissance associés à un système de contrôle.
Les deux premiers systèmes hybrides peuvent être qualifiés d'optoélectroniques, le troisième peut être purement optique ou optoélectronique, tandis que le quatrième est purement électronique.

Plus particulièrement, le domaine technique concerné est la réalisation de systèmes hybrides optoélectroniques, comprenant :
une partie optique basée sur au moins un élément photosensible permettant de générer des porteurs de charges électriques à partir de photons incidents (par exemple matrice de bolomètres, de photodiodes, ou de photoconducteurs) ; et une partie électronique consistant en un circuit de lecture intégré sur un substrat semi-conducteur permettant de lire individuellement le signal de chaque pixel de la partie optique. Un pixel appartenant au système optoélectronique peut contenir un unique élément photosensible ou une pluralité d'éléments photosensibles connectés entre eux.

Il existe des technologies d'imageurs où la couche photosensible est constituée d'une première famille de matériaux semi-conducteurs et le circuit intégré de lecture est réalisé dans un substrat d'une seconde famille de matériaux semi-conducteurs différente de la première. Les photo-détecteurs sont réalisés via des matériaux semi-conducteurs de type III-V tel que l'arséniure de gallium, arséniure d'indium, nitrure de gallium, antimoniure de gallium, phosphure de bore. Les photo-détecteurs peuvent en outre être réalisés via des matériaux semi-conducteurs de type II-VI. Pour construire un système hybride, il est nécessaire d'assembler les photo-détecteurs et de les interconnecter avec le circuit de lecture intégré sur un substrat en silicium.

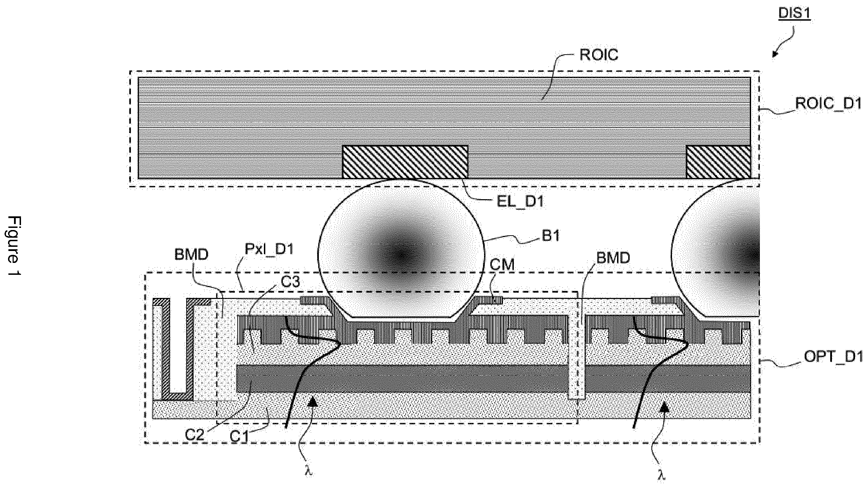

La figure 1 illustre une vue en coupe partielle d'un système hybride optoélectronique selon l'état de l'art ayant une partie optique comprenant un réseau de diffraction en métal à l'arrière de chaque pixel.

Le dispositif optoélectronique Dis1 illustré sur la figure 1 est un imageur infrarouge à transport vertical. Il se compose d'une partie optique OPT_D1 comprenant au moins un pixel Pxl_D1 et d'une partie électronique consistant en un circuit intégré de lecture ROIC_D1 comprenant au moins une électrode enterrée EL_D1.

Le circuit intégré de lecture ROIC_D1 est réalisé au moyen d'une pluralité de transistors et de couches minces en matériau conducteurs, semi-conducteurs ou diélectriques en technologie CMOS (Complementary Metal-Oxide-Semiconductor) sur un substrat en silicium. Pour chaque pixel PxI_D1, une électrode enterrée EL_D1 est associée pour lire les signaux générés par les porteurs de charges photo générés par la structure photo détectrice d'un pixel Pxl_D1.

Concernant la partie optique du dispositif, elle comprend une pluralité de couches C1, C2, C3 avec C1 et C3 deux couches conductrices obtenues par le dopage de type N+ d'un matériau semi-conducteur de type III-V (ou II-VI) et C2 une couche semi-conductrice (C2 pouvant être un empilement de couches de matériaux semi-conducteurs de type III-V (ou II-VI) confinée entre les couches C1 et C3. La couche C2 joue le rôle de la structure photo-détectrice du pixel Pxl_D1. Une couche de métal CM est déposée sur la couche conductrice C3 pour former un contact métallique supérieur associé exclusivement à chaque pixel. La structuration de l'interface C3/CM définit un réseau de diffraction. Chaque pixel de la partie optique OPT_D1 est séparé d'un pixel adjacent du détecteur matriciel au moyen d'une barrière en matériau diélectrique BMD. La couche inférieure C1 est commune à une pluralité de pixels et est connectée au potentiel électrique V_{INF} représentant une masse électrique pour tout le dispositif Dis1.

Dans le dispositif Dis1, la couche métallique C1 est un conducteur transparent (ou peu absorbant) qui laisse passer la lumière. Cela rend l'introduction d'une structure de type MIM (Métal-Isolant-Métal) impossible car dans la structure MIM il est nécessaire d'avoir une couche C1 opaque à la lumière incidente.

Dans le cadre de la description de l'invention, on entend par hybridation l'ensemble d'opérations et de techniques spécifiques pour combiner deux parties ayant des fonctions différentes (par exemple, le circuit de lecture ROIC_D1 et la matrice photo détectrice OPT_D1). L'hybridation d'un système optoélectronique induit les problématiques technologiques interdépendantes suivantes :
- l'assemblage de la partie optique et la partie électronique mécaniquement sans affecter les performances optiques et/ou électriques du dispositif hybride.
- la pixellisation consistant en la création des pixels et la création d'un accès individualisé au signal généré par chacun des pixels de la matrice de la partie optique.
- l'interconnexion consistant en la création d'une architecture d'interconnexion électrique entre chacun des pixels Pxl_D1 et l'électrode de lecture associée audit pixel.

Dans le cas de l'architecture décrite à la figure 1, l'hybridation est réalisée pour chaque pixel au moyen d'une bille métallique B1 qui connecte électriquement l'électrode de lecture EL_D1 à la couche de métal CM formant le contact métallique supérieur associé exclusivement au même pixel. La bille B1 est, par exemple, réalisable avec des billes d'Indium ou micro-piliers en cuivre permettant à chaque pixel d'avoir un contact individualisé avec le circuit de lecture ROIC. Il faut alors fermer le circuit électrique par un contact commun en face avant du photo détecteur, que doit nécessairement traverser le flux incident. En effet, la couche C1 est nécessairement transparente (ou faiblement absorbante) à l'optique étant du côté de l'onde incidente détectée. Cela rend l'intégration de résonateurs de type MIM dans le dispositif selon l'état de l'art impossible techniquement.

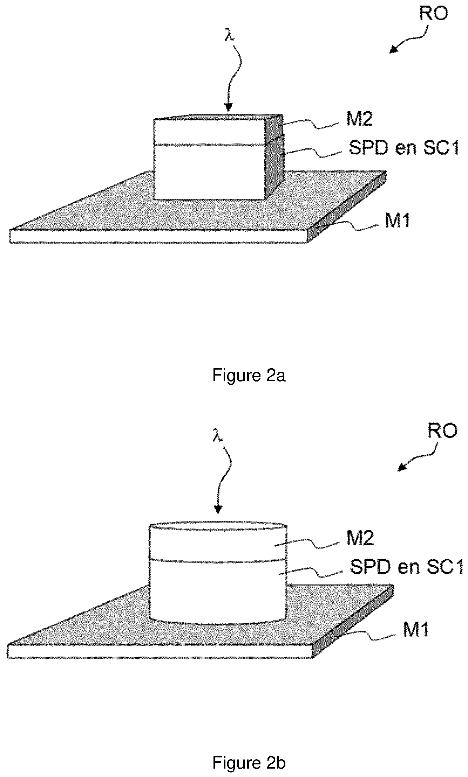

Les figures 2a et 2b illustrent deux exemples de résonateurs optiques RO de type MIM (Métal/Isolant/ Métal). Il est possible de réaliser un nano-résonateur optique via une microstructure comprenant une structure photo-détectrice SPD réalisée dans un matériau semi-conducteur SC1, une première couche métallique réflectrice M1 jouant le rôle de miroir et une seconde couche métallique supérieure M2 jouant le rôle d'un élément rayonnant d'antenne sous-longueur d'ondes. La structure photo-détectrice PD est confinée entre la couche métallique réflectrice M1 et la couche métallique supérieure M2.

Les solutions techniques selon l'état de l'art des méthodes de pixellisation, d'assemblage et d'interconnexion sur circuit de lecture ne sont pas applicables pour un système optoélectronique basé sur la technologie de résonateurs optiques de type MIM, à cause de la présence du réflecteur métallique en face non incidente. Le problème qui se pose pour utiliser une telle technologie est le suivant : soit la face incidente est du côté miroir commun, ce qui n'est pas possible du fait qu'il est opaque, soit la face incidente est du côté de la couche métallique supérieure M2, mais dans ce cas l'interconnexion devient non-réalisable avec les architectures de dispositifs selon l'état de l'art.

L'invention propose une structure de pixel formé par une pluralité de résonateurs optiques interconnectés au moyen d'une microstructure de connexion pour résoudre les problématiques de pixellisation, d'assemblage et d'interconnexion d'un dispositif optoélectronique comprenant au moins un pixel comprenant des résonateurs connectés à une unique électrode enterrée de lecture du circuit intégré de lecture.

### Art antérieur/ Restrictions de l'état de l'art

La demande de brevet américaine US 1998 5773831A décrit un détecteur d'image infra-rouge comprenant une pluralité de résonateurs optiques qui forment la matrice de détection. L'inconvénient de la solution décrite par cette demande est que la couche photo-détectrice couvre l'intégralité de la surface de la matrice de détection augmentant ainsi la génération de bruit et/ou de courant d'obscurité indésirable.

La demande de brevet américaine US 2011 0156194A1 décrit un détecteur d'image infra-rouge comprenant une pluralité de résonateurs optiques qui forment la matrice de détection. La connexion entre un pixel et le circuit de lecture est réalisée au moyen d'une structure sous forme de clou connecté à une bille métallique. L'inconvénient de la solution décrite par cette demande est que la structure d'interconnexion comprenant des billes métalliques présente une limite physique à l'augmentation de la résolution vu la taille des billes métalliques d'interconnexion. De plus, la couche photo-détectrice couvre l'intégralité de la surface de la matrice de détection augmentant ainsi la génération de bruit et/ou de courant d'obscurité indésirable. De plus, on cite un autre inconvénient lié à la baisse de la performance optique car les photons incidents sur la zone de contact ne seront pas collectés, d'où une perte d'efficacité quantique du détecteur selon l'état de l'art. Les documents EP 3 084 843 A1 et WO 2019/025342 A1 décrivent des dispositifs optoélectroniques selon l'art antérieur.

### Réponse au problème et apport solution

Pour pallier les limitations des solutions existantes en ce qui concerne la pixellisation, l'assemblage et l'interconnexion d'un dispositif optoélectronique comprenant au moins un résonateur optique connecté à une unique électrode de lecture d'un circuit intégré de lecture, l'invention propose plusieurs modes de réalisation d'une structure de pixel comprenant une pluralité de résonateurs optiques interconnectés et basés sur la technologie MIM ; la structure de pixel selon l'invention est compatible avec un système hybride optoélectronique. L'invention propose en outre des procédés de fabrication pour la réalisation des différents modes de réalisation de l'invention. Les procédés proposés par l'invention concernent des procédés compatibles avec une chaine de production silicium pour la technologie CMOS et des procédés de fabrication de plaquettes (« wafer » en anglais) à base de semiconducteurs de type III-V ou II-VI. Avantageusement, la solution technique selon l'invention permet de réaliser une hybridation de detecteurs matriciels dans le domaine de l'imagerie infrarouge (longueur d'onde de 1µm à 70µm, donc comprenant le THz), et en particulier les spectres du MWIR (mid-wave infrared, 3-5µm) et du LWIR (long-wave infrared, 8-12µm) pour l'imagerie thermique. L'architecture proposée par l'invention permet d'améliorer la performance de ce type de dispositif car l'hybridation du système est adaptée aux contraintes techniques des nano-résonateurs optiques de type MIM.

### Résumé / Revendications

L'invention a pour objet un dispositif optoélectronique comprenant :
▪ au moins un pixel, un pixel comprenant :
   ∘ une pluralité de résonateurs optiques, chaque résonateur optique comprenant une structure photo-détectrice confinée entre une première couche métallique réflectrice et une seconde couche métallique ;
   ∘ et une microstructure de connexion disposée sur un support en matériau diélectrique et configurée pour connecter électriquement entre elles les secondes couches métalliques des résonateurs optiques appartenant au même pixel ;
▪ un circuit intégré de lecture disposé sur un substrat et assemblé audit pixel ; le circuit de lecture comprenant une électrode de lecture enterrée associée audit pixel et une couche externe métallique ou diélectrique.

L'ensemble comprend au moins la première couche métallique et la couche externe du circuit intégré de lecture étant dénommé structure planaire d'assemblage.

Les secondes couches métalliques des résonateurs d'un pixel sont connectées à l'électrode de lecture associée au moyen d'un via métallique connecté à la microstructure de connexion et traversant le support.

Selon un aspect particulier de l'invention, au moins une dimension d'un résonateur, choisie parmi largeur, longueur, est comprise dans l'intervalle [λ/2n - 50% ; λ/2n + 50%] avec :
λ longueur d'onde incidente ;
n indice de réfraction effectif de la structure photo-détectrice.

Selon un aspect particulier de l'invention, la hauteur de la structure photo-détectrice est comprise dans l'intervalle [λ/4n - 50% ; λ/2n + 50%] avec :
λ longueur d'onde incidente ;
n indice de réfraction effectif de la structure photo-détectrice.

Selon un aspect particulier de l'invention, la distance entre deux pixels adjacents est supérieure ou égale à la longueur d'onde absorbée par un résonateur optique divisée par le double de l'indice de réfraction effectif de la structure photo-détectrice.

Selon un aspect particulier de l'invention, le via métallique est isolé électriquement des couches métalliques réflectrices des résonateurs dudit pixel.

Selon un aspect particulier de l'invention, la seconde couche métallique couvre la totalité de la surface de la structure photo-détectrice.

Selon un aspect particulier de l'invention, la seconde couche métallique couvre une partie de la surface de la structure photo-détectrice. La seconde couche métallique est intégralement couverte par une couche d'encapsulation en matériau diélectrique.

Selon un aspect particulier de l'invention, le dispositif optoélectronique comprend en outre un anneau d'arrêt de gravure en un matériau diélectrique disposé sur la surface de la structure photo-détectrice.

Selon un aspect particulier de l'invention, la couche externe du circuit intégré de lecture est une couche métallique commune à tous les résonateurs dudit au moins un pixel, et à tous les pixels le cas échéant. Ladite couche externe métallique est connectée à la masse électrique.

La couche métallique réflectrice est commune à tous les résonateurs dudit au moins un pixel, et à tous les pixels le cas échéant. Le via métallique traverse ladite structure d'assemblage et une partie du circuit intégré de lecture jusqu'à l'électrode de lecture.

Selon un aspect particulier de l'invention, la structure planaire d'assemblage est structurée de manière à former des structures élémentaires d'assemblage individualisées pour chaque électrode. Lesdites structures élémentaires d'assemblage sont isolées électriquement les unes des autres. Une structure élémentaire d'assemblage associée à une électrode d'un pixel est connectée électriquement à ladite électrode et au via métallique dudit pixel.

L'invention a pour objet en outre un capteur d'image matriciel comprenant un dispositif optoélectronique selon l'invention.

L'invention a pour objet en outre un procédé de fabrication d'un dispositif optoélectronique, le procédé comprenant les étapes consistant à :
- assembler d'une part une première structure planaire comprenant un premier substrat, un ensemble d'au moins une couche photo-détectrice et d'une première couche métallique réflectrice ;
   et d'autre part un circuit intégré de lecture déposé sur un deuxième substrat et comprenant au moins une électrode de lecture enterrée et une couche externe métallique ou diélectrique.
   L'ensemble comprenant au moins la première couche métallique et la couche externe du circuit intégré de lecture forme une structure planaire d'assemblage. La structure planaire d'assemblage est soit continue, soit structurée. La structure planaire d'assemblage structurée comprend des structures élémentaires d'assemblage individualisées isolées électriquement entre elles.
   Lorsque la structure planaire d'assemblage est continue, l'électrode de lecture enterrée est isolée électriquement de la structure planaire d'assemblage continue.
   Lorsque la structure planaire d'assemblage est structurée, l'électrode de lecture enterrée est connectée électriquement à une structure élémentaire d'assemblage.
- détacher le premier substrat ;
- réaliser au moins un pixel associé à une électrode enterrée comprenant les sous-étapes de :
   ∘ réaliser une pluralité de résonateurs optiques en :
      • Gravant sélectivement chacune des couches dudit ensemble d'au moins une couche photo-détectrice pour réaliser une pluralité de structures photo-détectrices ;
      • Déposant une seconde couche métallique sur chaque structure photo-détectrice ;
      lorsque la structure planaire d'assemblage est structurée, la structure photo-détectrice est localisée en regard d'une structure élémentaire d'assemblage individualisée.
   ∘ réaliser un support en matériau diélectrique entre les résonateurs et connecter lesdits résonateurs optiques entre eux-mêmes au moyen d'une microstructure de connexion disposée sur ledit support ;
   ∘ réaliser un via métallique traversant le support de manière à connecter les secondes couches métalliques des résonateurs à l'électrode enterrée associée via la microstructure de connexion.

Selon un aspect particulier de l'invention, lorsque la structure planaire d'assemblage est continue, l'étape de réalisation du via métallique comprend les sous-étapes de :
- graver un trou d'interconnexion traversant la structure d'assemblage jusqu'à l'électrode enterrée ;
- remplir le trou d'interconnexion par un matériau conducteur pour connecter électriquement les secondes couches métalliques à l'électrode enterrée.

L'étape de réalisation du support est telle que ledit support ne couvre pas le trou d'interconnexion.

Selon un aspect particulier de l'invention, lorsque la structure planaire d'assemblage est structurée, l'étape de réalisation du via métallique comprend les sous-étapes de :
- graver un trou d'interconnexion traversant le support jusqu'à la structure élémentaire d'assemblage connectée à l'électrode enterrée ;
- remplir le trou d'interconnexion par un matériau conducteur pour connecter électriquement les secondes couches métalliques à la structure élémentaire d'assemblage connectée à l'électrode enterrée.

Selon un aspect particulier de l'invention, le procédé de fabrication d'un dispositif optoélectronique comprend en outre une étape d'encapsulation du pixel comprenant les sous-étapes suivantes :
- déposer (401) une couche d'encapsulation en matériau diélectrique (ENC) couvrant les secondes couches métalliques (M2) et la microstructure de connexion (MC).
- graver sélectivement (402) la couche d'encapsulation (ENC) pour garder au moins les parties couvrant la première couche métallique (M1) et la microstructure de connexion (MC).

Selon un aspect particulier de l'invention, le procédé de fabrication d'un dispositif optoélectronique selon l'invention comprend :
- une étape de dépôt d'une couche d'arrêt de gravure sur une couche externe dudit ensemble d'au moins une couche photo-détectrice préalablement à l'étape de réalisation d'au moins un pixel associé à une électrode enterrée.
L'étape de réalisation d'au moins un pixel comprend en outre les sous-étapes suivantes :
▪ graver sélectivement la couche d'arrêt de gravure pour réaliser pour chaque résonateur un anneau d'arrêt de gravure disposé sur une partie de la surface de la structure photo-détectrice servant à contenir la première couche métallique.

Selon un aspect particulier de l'invention, le matériau conducteur déposé pour la réalisation de la seconde couche métallique (M2) et du via métallique (V1) est l'or ou le titane ou le platine.

Selon un aspect particulier de l'invention, le matériau conducteur déposé pour la réalisation de la seconde couche métallique et du via métallique est le cuivre ou l'aluminium ou le tungstène.

Selon un aspect particulier de l'invention, l'étape de réalisation d'une pluralité de résonateurs optiques et l'étape de réalisation du via métallique s'effectuent par lithographie puis gravure, la technologie de lithographie étant choisie parmi : par faisceau d'électrons ; par nano-impression ; par lithographie optique, et la technologie de gravure étant choisie parmi la gravure ionique, gravure chimique ou plasma.

### Description

D'autres caractéristiques et avantages de la présente invention apparaîtront mieux à la lecture de la description qui suit en relation aux dessins annexés suivants.
La figure 1 illustre une vue en coupe partielle d'un système hybride optoélectronique selon l'état de l'art ayant une partie optique comprenant un réseau de diffraction.
La figure 2a illustre une vue en perspective d'un exemple de résonateur optique sous forme cubique.
La figure 2b illustre une vue en perspective d'un exemple de résonateur optique sous forme cylindrique.
La figure 3 illustre un schéma de deux résonateurs optiques intégrés dans un détecteur matriciel d'images dans le domaine de fréquences infrarouges.
La figure 4a illustre un premier mode de réalisation selon l'invention de l'hybridation d'un couple de résonateurs optiques d'un même pixel appartenant à un système hybride optoélectronique.
La figure 4b illustre un deuxième mode de réalisation de l'hybridation d'un couple de résonateurs optiques d'un même pixel appartenant à un système hybride optoélectronique.
La figure 4c illustre un procédé générique de fabrication pour réaliser l'hybridation d'un pixel appartenant à un système hybride optoélectronique.
La figure 4d illustre un procédé de fabrication pour réaliser l'hybridation d'un pixel appartenant à un système hybride optoélectronique selon le premier mode de réalisation illustré sur la figure 4a.
La figure 4e illustre un procédé de fabrication pour réaliser l'hybridation d'un pixel appartenant à un système hybride optoélectronique selon le deuxième mode de réalisation illustré sur la figure 4b.
La figure 4f illustre un troisième mode de réalisation de l'hybridation d'un couple de résonateurs optiques d'un même pixel appartenant à un système hybride optoélectronique.
La figure 5a illustre un quatrième mode de réalisation de l'hybridation d'un couple de résonateurs optiques d'un même pixel appartenant à un système hybride optoélectronique.
La figure 5b illustre un procédé de fabrication pour réaliser l'hybridation d'un pixel appartenant à un système hybride optoélectronique selon le quatrième mode de réalisation.
La figure 5c illustre un cinquième mode de réalisation de l'hybridation d'un couple de résonateurs optiques d'un même pixel appartenant à un système hybride optoélectronique.
La figure 6a illustre un sixième mode de réalisation de l'hybridation d'un couple de résonateurs optiques d'un même pixel appartenant à un système hybride optoélectronique.
La figure 6b illustre un procédé de fabrication pour réaliser l'hybridation d'un pixel appartenant à un système hybride optoélectronique selon le sixième mode de réalisation.
La figure 7a représente une vue de dessus d'un exemple d'un dispositif optoélectronique comprenant plusieurs pixels selon l'invention.
La figure 7b représente une vue de dessus d'un exemple d'un dispositif optoélectronique comprenant un unique pixel selon l'invention.

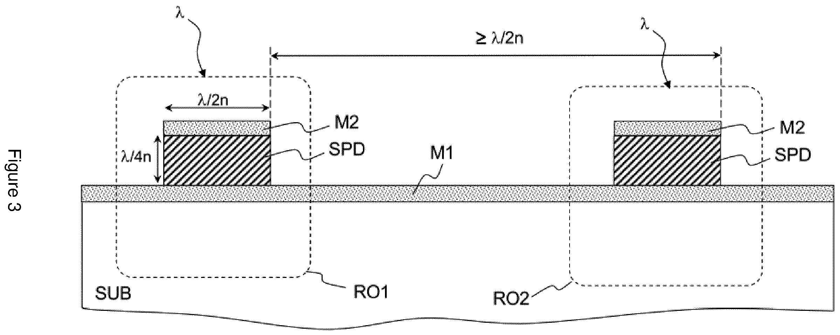

Nous allons commencer par introduire la structure de base d'un couple de résonateurs optiques RO₁ et RO₂ non intégrés dans un système hybride. La figure 3 illustre un schéma de deux résonateurs optiques d'un détecteur matriciel d'images dans le domaine de fréquences infrarouges.

Les résonateurs optiques RO₁ et RO₂ présentés à la figure 3 reposent sur un substrat SUB en matériau semi-conducteur. Nous nous limitons à ce stade à représenter le substrat SUB pour simplifier la représentation.

Chaque résonateur optique RO₁ ou RO₂ comprend une structure photo-détectrice SPD réalisée dans un premier matériau semi-conducteur SC1 et définissant une mesa, une première couche métallique réflectrice M1 et une seconde couche métallique M2. La structure en mesa photo-détectrice SPD est confinée entre la première couche métallique réflectrice M1 et la seconde couche métallique M2. On entend par « mesa » une microstructure ou nanostructure correspondant à un volume reposant sur un plan et ayant une surface supérieure plane.

La structure photo-détectrice PD est située dans la cavité photonique que constitue le résonateur optique RO1 (ou RO2). Cette structure est réalisée via un matériau de type III-V tel que, à titre d'exemple, l'arséniure de gallium, arséniure d'indium, nitrure de gallium, antimoniure de gallium, phosphure de bore, ainsi que leurs alliages ternaires, quaternaires ou quinaires.

Alternativement, il est possible de réaliser des homo-jonctions photo détectrices obtenues via des variations ou gradients de dopage d'une structure en matériau semi-conducteur.

Alternativement, il est possible de réaliser la structure photo-détectrice d'un résonateur optique RO1 (ou RO2) avec un empilement d'une pluralité de couches. L'empilement est composé de matériaux semi-conducteurs différents formant ainsi une hétéro-structure photo détectrice. Les matériaux semi-conducteurs utilisés pour la réalisation de l'empilement des couches de l'hétéro-structure photo détectrice sont de type III-V tel que, à titre d'exemple, l'arséniure de gallium, arséniure d'indium, nitrure de gallium, antimoniure de gallium, phosphure de bore, ainsi que leurs alliages ternaires ou quaternaires ou quinaires. Le dopage de ces couches (N ou P) permet de définir des architectures de photodiodes ou de photoconducteurs.

Selon un aspect particulier de l'invention, la structure photo détectrice correspond à un ensemble de boites quantiques colloïdales CQD (acronyme du terme anglais Colloidal Quantum Dots).

La structure photo détectrice SPD repose sur la couche métallique réflectrice M1 jouant le rôle de miroir.

Généralement, la couche réflectrice M1 est commune à tous les résonateurs optiques RO du dispositif hybride OPT étant connectée électriquement à la masse électrique du dispositif.

Dans un autre mode de réalisation, il est envisageable d'avoir une couche réflectrice M1 dédiée à chaque pixel et donc pour les résonateurs optiques RO interconnectés appartenant audit pixel.

Dans un autre mode de réalisation, il est envisageable d'avoir une couche réflectrice M1 dédiée à chaque résonateur optique RO du détecteur d'image matriciel.

L'association de la couche métallique réflectrice M1 avec la seconde couche métallique supérieure M2 et avec la structure photo-détectrice définit une nano-antenne sous-longueur d'onde pour un résonateur optique tel que décrit sur la figure 1. La couche métallique supérieure M2 est déposée sur la surface apparente de la mesa photo détectrice SPD. Le dimensionnement à l'échelle nanométrique du résonateur RO lui permet d'absorber des modes particuliers d'une onde incidente du côté de la couche supérieure M2 et ayant une longueur d'onde λ dans le domaine de l'infra-rouge.

A titre indicatif, la couche réflectrice M1 et la couche supérieure M2 peuvent être réalisées avec de l'or (Au) ayant une épaisseur de couche variant entre 25nm et 500nm pour la couche réflectrice M1 et une épaisseur de couche variant entre 150nm et 1000nm pour une couche supérieure M2. De plus et à titre d'exemple, il est possible de réaliser les couches métalliques M1 et M2 avec du cuivre, l'aluminium, le palladium, le platine, l'argent et le tungstène.

Avantageusement, si on désigne par n l'indice de réfraction du matériau de la mésa photo détectrice SPD, le résonateur RO₁ (ou RO₂) est dimensionné de la manière suivante : au moins une dimension d'un résonateur (et donc de la couche supérieure M2), choisie parmi la largeur ou la longueur, est comprise dans l'intervalle [λ/2n - 50% ; λ/2n + 50%] et la hauteur de la couche photo détectrice PD est comprise dans l'intervalle [λ/4n - 50% ; λ/2n + 50%]. De plus, la distance séparant deux résonateurs optiques adjacents est supérieure à λ/2n.

Les épaisseurs des couches métalliques M1 et M2 du résonateur sont au-dessus de l'épaisseur de peau et en dessous de la limite de diffraction.

Ces intervalles de dimensionnement permettent de réaliser le fonctionnement de résonateur par les microstructures RO₁ et RO₂ décrites précédemment. En effet, chacun des résonateurs exalte le couplage lumière-matière entre le mode de cavité verticale TM0 et la structure photosensible SPD, permettant d'exalter la réponse des technologies à faible efficacité quantique, comme les détecteurs inter-sous-bandes à puits quantiques (QWIPs et QCDs) ou les boites quantiques colloïdales II-VI (CQD).

Pour un résonateur, lorsque la structure est résonante, la lumière est alors guidée et concentrée dans la cavité photo-détectrice SPD sous la couche supérieure M2, permettant de garantir une fonction de transfert de modulation (MTF) optimale, en diminuant (voir supprimant complètement) les phénomènes de diaphonies (crosstalk en Anglais) optiques et électriques entre les résonateurs. Sachant que dans le dispositif hybride OPT, chaque pixel correspond à un ou plusieurs résonateurs connectés entre eux, la structure décrite par la figure 3 permet alors de réduire le pas pixel à sa dimension ultime correspondant à un pas sous-longueur d'onde. De plus, le volume effectif de semi-conducteur est beaucoup plus réduit que dans les dispositifs optoélectroniques planaires. Ainsi, le courant et le bruit d'obscurité sont réduits dans le dispositif OPT comprenant des résonateurs ROᵢ. Nous rajoutons que cette architecture est intrinsèquement rapide car elle présente une faible capacité du pixel.

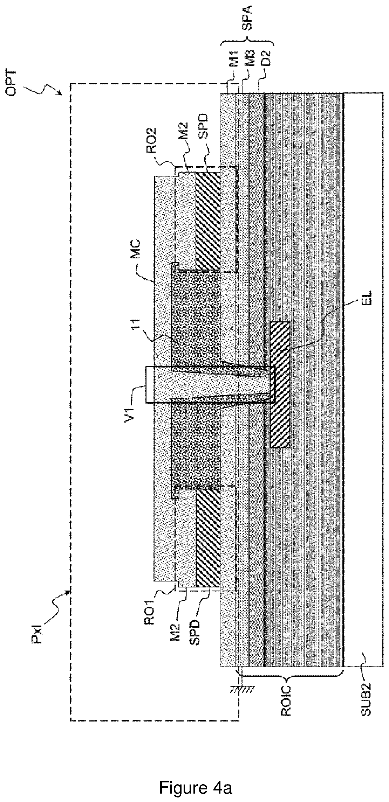

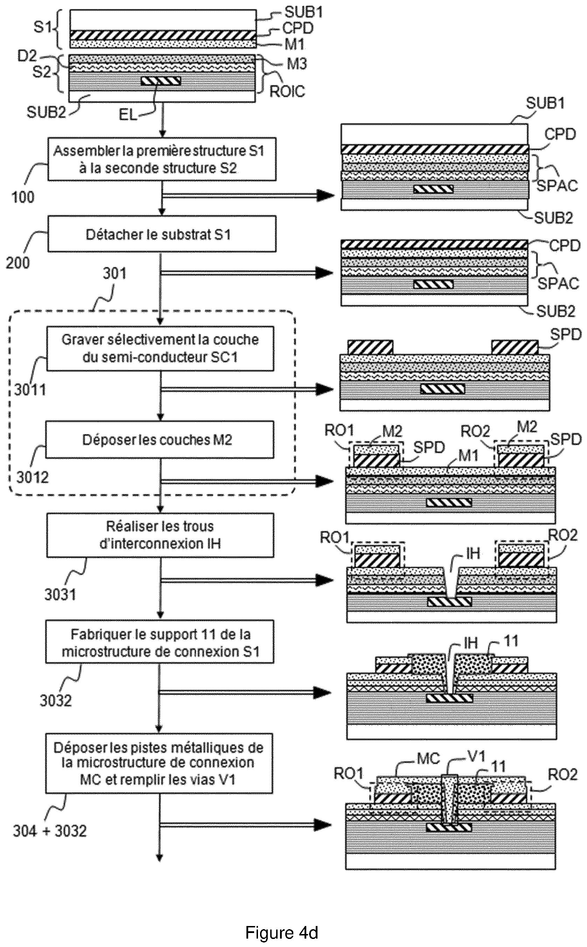

La figure 4a illustre un premier mode de réalisation d'une pluralité de résonateurs optiques RO₁, RO₂ interconnectés pour former un pixel Pxl selon l'invention. Le pixel Pxl est hybridé avec un circuit intégré de lecture ROIC en interconnectant électriquement les couches métalliques supérieures M2 des résonateurs RO₁, RO₂ appartenant à un même pixel Pxl au moyen d'une microstructure de connexion MC, et en connectant électriquement lesdites couches supérieures à l'électrode de lecture EL enterrée appartenant au circuit intégré de lecture ROIC et destinée à lire les signaux photo-générés par le pixel Pxl.

Un dispositif hybride optoélectronique comprend au moins un pixel Pxl appartenant à une matrice de détection. Dans la solution décrite par l'invention, chaque pixel comprend une pluralité de résonateurs optiques RO dont la structure photo détectrice SPD est réalisée dans un premier matériau semi-conducteur SC1 généralement de type III-V. Le dispositif comprend en outre un circuit intégré de lecture ROIC réalisé dans un second matériau semi-conducteur SC2 généralement en silicium et disposé sur un substrat en silicium Sub2. Le circuit de lecture ROIC est généralement réalisé au moyen d'une pluralité de transistors et de couches minces en matériau conducteurs, semi-conducteurs ou diélectriques selon la technologie CMOS (non représentés ici pour simplifier l'illustration) sur le substrat Sub2 en silicium.

La plaquette (« wafer » en Anglais) comprenant les couches composant la partie optique et la plaquette comprenant le circuit de lecture ROIC sont assemblées. L'opération d'assemblage des deux structures forme une structure planaire d'assemblage SPA comprenant un empilement de couches appartenant à la partie optique du système ou au circuit intégré de lecture ROIC. Dans l'exemple illustré par la figure 4a, la structure planaire d'assemblage est composée d'un côté de la couche métallique réflectrice M1 appartenant à la partie optique et de l'autre côté de l'empilement de couche composé de la couche métallique M3 connectée à la masse électrique du circuit ROIC et la couche de passivation en diélectrique D2 du circuit ROIC. Plus de détails sur le procédé d'assemblage seront exposés ultérieurement.

Alternativement, Il est possible de réaliser un assemblage non pas métal-métal comme illustré sur la figure 4a mais un assemblage diélectrique-diélectrique. La structure planaire d'assemblage SPA dans ce cas est composée de la couche de passivation externe diélectrique de la partie optique et la couche de passivation externe en diélectrique du circuit intégré de lecture ROIC ainsi que de la couche réflectrice M1.

Dans le premier mode de réalisation illustré par la figure 4a, les couches M1, M3 et D2 (D2 étant une couche en diélectrique) de la structure planaire d'assemblage SPA forment ensemble un seul empilement présentant une continuité électrique et spatiale à travers la surface occupée par un pixel ou à travers la surface de toute la plaquette du système. Dans ce mode de réalisation, la couche réflectrice M1 est commune à tous les résonateurs appartenant à un même pixel. Il est envisageable aussi de réaliser une unique couche réflectrice M1 commune à tous les pixels Pxl de la matrice.

Comme décrit précédemment, le résonateur optique RO comprend une structure photo-détectrice SPD réalisée en matériau semi-conducteur de type III-V et définissant une mesa par exemple, une couche métallique supérieure M2 et une couche métallique réflectrice M1. La structure photo-détectrice SPD est confinée entre la couche métallique réflectrice M1 et la couche métallique supérieure M2.

Dans un dispositif selon l'invention, les résonateurs RO₁ et RO₂ appartenant à un même pixel sont connectés au moyen d'une microstructure de connexion MC reposant sur un support 11 en matériau diélectrique et comprenant une ou plusieurs pistes métalliques 12 déposées sur ledit support 11. Les pistes métalliques 12 connectent les couches métalliques supérieures M2 des résonateurs optiques d'un même pixel.

De plus, l'hybridation d'un pixel Pxl appartenant au détecteur d'image OPT selon l'invention est réalisée au moyen d'un via métallique de connexion V1 connectant électriquement les couches métalliques supérieures M2 des résonateurs optiques RO₁ et RO₂ (partie optique) appartenant au pixel Pxl à l'électrode de lecture EL associée au même pixel et enterrée dans la plaquette du circuit ROIC (partie électrique). Le via de connexion V1 est traversant à partir d'un point quelconque de la microstructure de connexion MC vers l'électrode enterrée EL en passant par le support diélectrique 11 et la structure planaire d'assemblage SPA. Cette solution permet de réaliser une pixellisation car elle permet de lire individuellement le signal généré par chaque pixel comprenant une pluralité de résonateurs ROᵢ. Cette solution est compatible avec un assemblage de type « wafer to wafer » pouvant être traduit par plaquette à plaquette tel que représenté sur la figure 4a à titre indicatif. Cette solution permet de réaliser une interconnexion d'un système hybride permettant la création d'une architecture d'interconnexion entre chacun des pixels Pxl et l'électrode de lecture associée à chaque pixel.

Cette solution est compatible aussi avec un assemblage de type « die to wafer » pouvant être traduit par puce à plaquette. On entend ici par puce un circuit intégré préalablement fabriqué sur une plaquette de semi-conducteur et préalablement découpé de la plaquette sans montage d'un boitier. Cette solution est compatible aussi avec un assemblage de type « multi-wafer to wafer » pouvant être traduit par multi-plaquette à plaquette.

Le via V1 doit traverser la structure planaire d'assemblage comprenant la couche métallique réflectrice connectée à la masse électrique et commune à l'ensemble des pixels de la matrice.

De plus, pour chaque pixel Pxl, le via V1 traversant le support 11 et la structure planaire d'assemblage SPA doit connecter les couches métalliques supérieures M2 à l'électrode enterrée de lecture EL.

Pour éviter un court-circuit avec les couches traversées (M1, M3, D2 par exemple), le via V1 est passivé en gardant une paroi latérale à partir du support 11 en matériau diélectrique à l'intérieur du via V1 pour l'isoler électriquement de la couche métallique réflectrice M1 et de la structure planaire d'assemblage SPA.

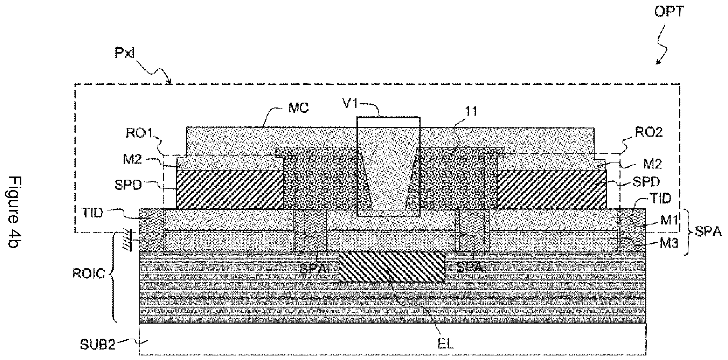

La figure 4b illustre un deuxième mode de réalisation du pixel selon l'invention comprenant une structure planaire d'assemblage structurée.

Le deuxième mode de réalisation diffère du premier mode de réalisation par les points suivants :
- la structure planaire d'assemblage SPA n'est pas continue sur toute la surface de la plaquette mais structurée tel que pour chaque électrode EL on réalise une structure élémentaire d'assemblage SPAI individualisée et pour chaque résonateur optique ROᵢ on réalise une structure élémentaire d'assemblage SPAI individualisée.
- les structures élémentaires d'assemblage SPAI sont isolées électriquement entre elles au moyen d'une pluralité de tranchées d'isolation TID en matériau diélectrique.
- chaque électrode de lecture (EL) est connectée électriquement à la structure élémentaire d'assemblage SPAI associée.
- le via métallique V1 traverse uniquement le support 11 et il est connecté électriquement avec la structure élémentaire d'assemblage SPAI associée à l'électrode de lecture EL et ainsi le via est connecté électriquement à l'électrode EL.

La structure d'un pixel de détecteur matriciel infrarouge selon l'invention décrite dans la figure 4a ou la figure 4b est réalisable via un procédé de fabrication basé sur les étapes technologiques d'une ligne de production pour la fabrication des circuits ou microsystèmes à base de semi-conducteurs III-V.

Par « procédé III-V » on entend les procédés trouvés dans des environnements de salle blanche traitant couramment des plaquettes (« wafers » en anglais) au format 100mm ou inférieurs. Les plaquettes sont souvent traitées individuellement, ou par lot de quelques unités au maximum. Une fraction majoritaire de la manipulation des tranches est manuelle. Les opérations de lithographies se font par des procédés contact ou par projection, avec des résolutions de l'ordre du µm allant jusqu'à 500nm. La structuration des couches et structures métalliques est réalisée par des dépôts de type « liftoff » ou gravure ionique. Les métaux généralement utilisés sont les métaux nobles comme le platine (Pt), l'or (Au) et l'argent (Ag). Les étapes technologiques de collage et de planarisation de type CMP sont peu courantes avec ce type de procédé.

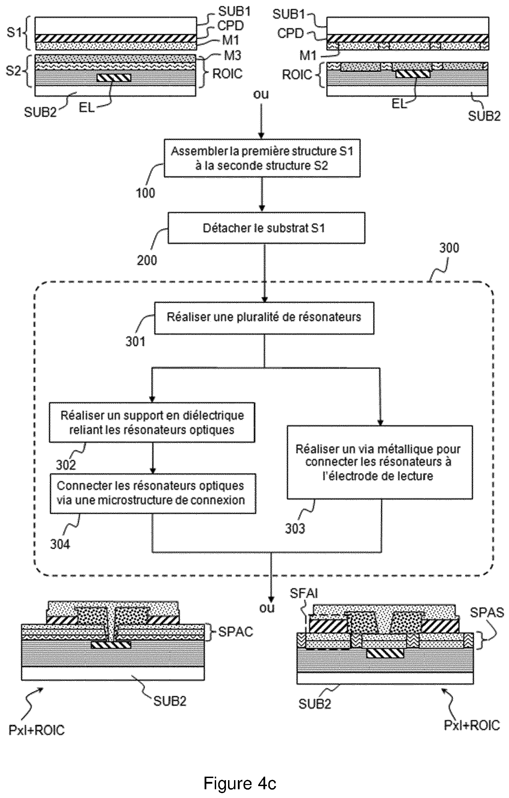

L'invention propose un procédé de type « procédé III-V » pour fabriquer et interconnecter une pluralité de résonateurs optiques ROi formant un pixel Pxl mais aussi pour réaliser l'assemblage, la pixellisation et l'interconnexion du pixel Pxl. Nous nous limiterons sur la figure 4c à représenter les étapes technologiques du procédé P1 pour un pixel Pxl1 comprenant deux résonateurs RO1 et RO2 pour simplifier la compréhension du procédé. Cependant, les étapes du procédé sont généralisables pour une pluralité de pixels appartenant au même système hybride et elles sont réalisables d'une façon simultanée pour toute la matrice de pixels.

Nous allons d'abord présenter les étapes technologiques de fabrication d'un pixel selon l'invention d'une façon générale sur la figure 4c.

La première étape 100 consiste à assembler d'une part une première structure planaire S1 comprenant un premier substrat Sub1, une couche photo-détectrice CPD en un matériau semi-conducteur de type III-V et une première couche métallique réflectrice M1 ; et d'autre part un circuit intégré de lecture ROIC, préalablement fabriqué, déposé sur un deuxième substrat Sub2 et comprenant au moins une électrode de lecture enterrée EL et une troisième couche métallique M3 généralement connectée à la masse électrique. L'ensemble comprenant au moins la première couche métallique M1 et la troisième couche métallique M3 couche métallique forment une structure planaire d'assemblage SPA suite à l'opération d'assemblage. La première structure S1 présente l'échantillon utilisé pour fabriquer la partie optique du système hybride.

Comme expliqué précédemment, il est envisageable d'utiliser pour la partie optique une première structure planaire S1 comprenant un empilement d'une pluralité de couches en différents matériaux semi-conducteurs formant ensemble une hétéro-structure de couches photo-détectrices (correspondant à CPD). Les couches superposées vont servir pour la fabrication des structures photo-détectrices SPD des résonateurs. Nous nous limitons à présenter une seule couche photo détectrice CPD dans les illustrations suivantes par soucis de simplification mais sans perte de généralité.

La structure planaire d'assemblage SPA peut être continue sur toute la surface de la plaquette (« wafer » en anglais) puisque la couche métallique réflectrice M1 et la couche métallique de masse électrique M3 sont continues et communes à tous les pixels du dispositif à fabriquer. Dans le cas d'une structure planaire d'assemblage continue SPAC, les électrodes de lecture EL sont isolées électriquement des couches formant la structure planaire d'assemblage continue SPAC.

Alternativement, la structure planaire d'assemblage SPA peut être structurée SPAS et comprenant des structures élémentaires d'assemblage SPAI individualisées pour chaque résonateur optique à fabriquer et pour chaque électrode de lecture EL. Les structures élémentaires d'assemblage SPAI sont isolées électriquement entre elles au moyen d'une pluralité de tranchées d'isolation TID en matériau diélectrique. Une structure élémentaire d'assemblage SPAI associée à une électrode est connectée électriquement à ladite électrode de lecture EL.

L'assemblage est réalisé par collage, technique en plein développement et qui constitue un progrès important pour la réalisation d'étapes technologiques dites « above IC », c'est-à-dire d'étapes réalisables directement sur la plaque du circuit de lecture ROIC, typiquement de type CMOS, et de manière collective sur l'ensemble des puces. Cette compatibilité avec les moyens de fabrication CMOS est adaptée à une baisse significative des coûts de production et à la possibilité d'atteindre des motifs technologiques de taille plus fine.

La deuxième étape 200 consiste à détacher le substrat Sub1 pour garder seulement le substrat Sub2 sur lequel est réalisé le circuit de lecture ROIC.

La troisième étape 300 consiste à réaliser un pixel selon l'invention pour chaque électrode de lecture enterrée EL. Cette étape comporte plusieurs sous-étapes réalisables d'une façon séquentielle ou en parallèle :
- la première sous étape 301 consiste à réaliser une pluralité de résonateurs optiques ROᵢ de rang i-0 à N avec N un entier strictement positif correspondant au nombre de résonateurs optiques appartenant audit pixel Pxl.
- la deuxième sous-étape 302 consiste à réaliser un support 11 en matériau diélectrique entre les résonateurs servant à assurer une phase de planarisation pour accueillir une microstructure de connexion MC composé de pistes métalliques 12 reposant sur ledit support 11.
- la troisième sous-étape 303 consiste à réaliser le via de connexion métallique V1 permettant de connecter électriquement directement ou indirectement la microstructure de connexion MC (et donc les couches supérieures M2 des résonateurs optiques) à l'électrode de lecture enterrée EL.
- la quatrième sous-étape 304 consiste à déposer un matériau conducteur pour réaliser la microstructure de connexion MC connectant entre eux-mêmes les couches métalliques supérieures M2 des résonateurs optiques ROᵢ dudit pixel Pxl.

L'exécution des sous-étapes 302, 303 et 304 comprend des opérations de dépôt de matériaux, de gravures et de lithographie réalisables en parallèle selon la structure du pixel fabriqué.

La figure 4c illustre avec plus de détails le procédé de fabrication selon l'invention d'un pixel comprenant deux résonateurs RO1 et RO2 selon le premier mode de réalisation décrit sur la figure 4a.

La première étape d'assemblage 100 est réalisée tel que décrit précédemment pour former une structure planaire d'assemblage continue SPAC. Le résultat de l'étape d'assemblage 100 est illustré dans la vue en coupe 100a où on observe la structure S1 assemblée au circuit de lecture ROIC tel que la structure planaire d'assemblage SPA soit continue. La structure planaire d'assemblage continue SPAC est constituée de la couche métallique réflectrice M1 appartenant à la première structure S1 et de l'empilement composé d'une couche métallique M3 connectée à la masse électrique du circuit de lecture ROIC et d'une couche de passivation du circuit ROIC notée D2 en matériau diélectrique. L'étape d'assemblage 100 assure alors la connexion électrique de la couche métallique réflectrice M1 à la masse électrique globale du système hybride. L'électrode de lecture EL est isolée électriquement de la structure planaire d'assemblage continue SPAC. La couche métallique réflectrice M1 est commune à tous les résonateurs optiques du pixel Pxl. La couche métallique de masse M3 est commune à l'ensemble des pixels du système optoélectronique. La deuxième étape 200 consiste à détacher le premier substrat Sub1 comme décrit précédemment.

Ensuite, la sous-étape 301 de réalisation des résonateurs ROi est réalisée en :
- gravant (sous-étape 3011) sélectivement la couche photo détectrice CPD pour réaliser pour chaque résonateur une structure photo-détectrice SPD. Sur l'illustration 3011a du résultat de cette sous-étape, on observe la structure photo-détectrice SPD sous forme de mésa reposant sur la couche métallique réflectrice commune M1.
- puis en déposant (sous-étape 3012) un matériau conducteur sur la surface supérieure de chacune des structures photo-détectrices SPD pour réaliser les couches métalliques supérieures M2 de chaque résonateur optique RO₁ (et RO₂). Cette opération est réalisable, par exemple, via un procédé de dépôt de type « lift-off ». Il s'agit d'une technique additive utilisée en microtechnique visant à créer des motifs d'un matériau cible (dans ce cas les couches supérieures M2) sur la surface d'un substrat (dans ce cas l'empilement des couches M1 et SPD) en utilisant un matériau sacrificiel (généralement une résine photosensible). La structure obtenue suite à la réalisation de la sous-étape 3012 est illustrée dans la vue en coupe 3012a. on observe la structure photo détectrice SPD confinée entre la couche métallique réflectrice M1, connectée à la masse électrique, et la couche métallique supérieure M2 pour chacun des résonateurs RO₁ et RO₂.

L'étape suivante 3031 est une sous-étape de la réalisation 303 du via métallique V1. Elle consiste à réaliser un trou d'interconnexion IH traversant la structure planaire d'assemblage continue SPAC jusqu'à l'électrode enterrée EL. Le trou d'interconnexion est réalisé au niveau de l'électrode de lecture EL dans une région « non-active » ne contenant aucun résonateur ROᵢ du pixel Pxl. La sous-étape 3031 est, par exemple, réalisée au moyen d'une opération de gravure ionique ou plasma. Le trou d'interconnexion IH obtenu suite à la réalisation de la sous-étape 3031 est illustré dans la vue en coupe 3031a.

L'étape suivante 302 consiste à fabriquer le support 11 en matériau diélectrique reliant les secondes couches métalliques M2 des résonateurs RO₁, RO₂ du même pixel Pxl. Le support 11 ne couvre pas le trou d'interconnexion IH tout en réalisant une paroi interne au trou d'interconnexion IH en diélectrique pour assurer la passivation du trou IH et ainsi le via V1. La passivation est nécessaire pour isoler électriquement le via V1 des couches traversées appartenant à la structure planaire d'assemblage SPA. La fabrication du support 11 prévu pour la microstructure de connexion MC est réalisable au moyen d'un procédé de planarisation compatible avec un procédé de type III-V.

Plus particulièrement, en utilisant une résine HSQ par exemple, une lithographie à faisceau d'électron permet une insolation localisée de la couche de HSQ. Sous l'action de l'exposition au faisceau d'électrons, la résine HSQ se réticule pour avoir un aspect semblable à un diélectrique à l'état solide et plus particulièrement le dioxyde de silicium SiO2. Il est alors possible de tracer avec une précision nanométrique des motifs solides à partir de la couche de HSQ. L'association d'une résine HSQ à une lithographie à faisceau d'électrons présente en outre un avantage important. En contrôlant la dose d'exposition de la HSQ aux électrons, il est possible de faire varier son épaisseur après révélation. Cela permet d'ajuster localement la hauteur de support 11 pour s'adapter aux divers reliefs de l'échantillon. Suite à la phase d'insolation de la résine et la solidification des motifs qui forment le support 11, les parties de la résine déposée non-solidifiées sont enlevées de la surface de la plaquette pour garder uniquement les parties solides réticulées de la résine.

La vue en coupe 304a illustre le résultat intermédiaire obtenu suite à la sous-étape 304 de fabrication du support 11.

La dernière sous-étape consiste à déposer un matériau conducteur sur le support 11 pour réaliser simultanément :
- la connexion (304) des résonateurs optiques RO₁ et RO₂ via une microstructure de connexion MC constituée d'au moins une piste métallique pour connecter électriquement entre eux-mêmes les secondes couches métalliques M2 des résonateurs RO₁ et RO₂ d'un même pixel Pxl ;
- et le remplissage (3032) du trou d'interconnexion (IH) pour connecter électriquement la microstructure de connexion MC à l'électrode enterrée (EL) et ainsi lesdites secondes couches métalliques M2.

Ainsi, le procédé P1 selon un mode de réalisation de l'invention permet de réaliser au moins un pixel Pxl d'un système optoélectronique comprenant une pluralité de résonateurs optiques tout en réalisant l'opération d'hybridation de la partie optique avec la partie électrique du système.

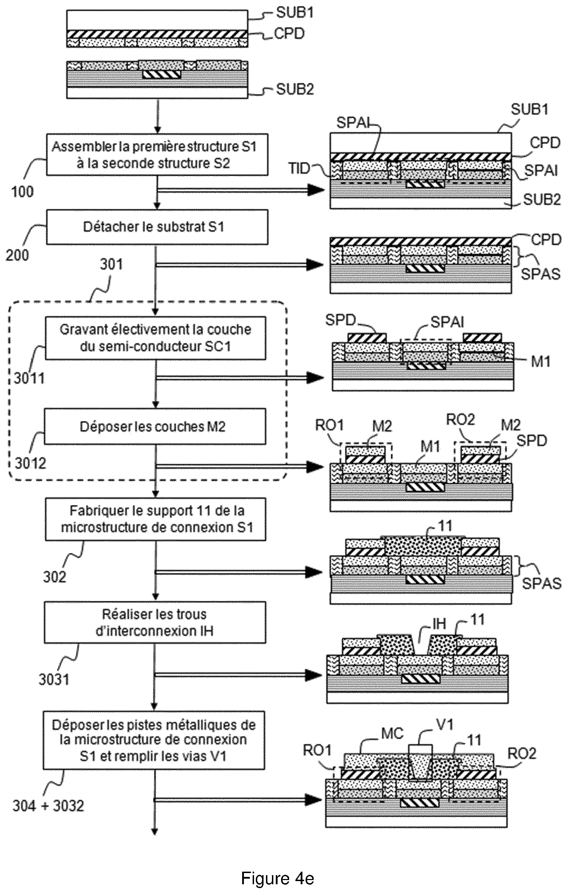

La figure 4e illustre avec plus de détails le procédé de fabrication selon l'invention d'un pixel comprenant deux résonateurs RO₁ et RO₂ selon le second mode de réalisation décrit sur la figure 4b.

La première étape d'assemblage 100 est réalisée pour former une structure planaire d'assemblage structurée SPAS tel que décrit précédemment. Le résultat de l'étape d'assemblage 100 est illustré dans la vue en coupe 100b où on observe la structure S1 assemblée au circuit de lecture ROIC tel que la structure planaire d'assemblage SPA soit structurée en comprenant des structures élémentaires d'assemblage individualisées SPAI pour chaque résonateur à fabriquer et pour chaque électrode de lecture EL. Lesdites structures élémentaires d'assemblage SPAI sont isolées électriquement entre-elles. L'électrode de lecture EL est connectée électriquement à la structure planaire élémentaire d'assemblage SPAI associée à ladite électrode.

La deuxième étape 200 consiste à détacher le premier substrat Sub1 comme décrit précédemment.

Ensuite, la sous-étape de réalisation des résonateurs optiques est réalisée comme décrit précédemment sur la figure 4c avec une contrainte supplémentaire : En effet, la gravure (3011) sélective de la couche photo détectrice (3011) est réalisée d'une façon ciblée de manière à obtenir des structures photo détectrices SPD localisées chacune en regard d'une structure élémentaire d'assemblage (SPAI) individualisée.

L'étape suivante de fabrication du support 11 en matériau diélectrique 302 est réalisée comme décrit pour le procédé illustré sur la figure 4c.

L'étape suivante 3031 est la réalisation un trou d'interconnexion IH traversant le support 11 fabriqué précédemment jusqu'à atteindre la structure planaire élémentaire d'assemblage individualisée SPAI connectée à l'électrode enterrée EL.

La dernière sous-étape consiste à déposer un matériau conducteur sur le support 11 pour réaliser simultanément :
- la connexion (304) des résonateurs optiques RO₁ et RO₂ via une microstructure de connexion MC constituées d'au moins une piste métallique pour connecter électriquement entre eux-mêmes les secondes couches métalliques M2 des résonateurs RO₁ et RO₂ d'un même pixel Pxl ;
- et le remplissage (3032) du trou d'interconnexion (IH) pour connecter électriquement la microstructure de connexion MC à la structure planaire élémentaire d'assemblage individualisée SPAI associée à l'électrode EL et ainsi connecter lesdites secondes couches métalliques M2 à l'électrode de lecture EL du pixel pxl associé.

Nous allons dans la partie suivante décrire d'autres modes de réalisation de la structure du pixel Pxl selon l'invention compatible avec un « procédé CMOS » d'une ligne de production en fonderie silicium. Par « procédé CMOS », on entend les procédés trouvés dans des environnements salle blanche traitant des plaquettes (ou « wafer ») de large format (200mm, 300mm, 450mm). Les plaquettes sont manipulées par des automates, et sont souvent traités par lots de 10 à 25 unités qui se branchent directement sur les équipements. Les opérations de lithographie sont des lithographies de type pas à pas réalisées par projection avec des résolutions largement submicroniques. La structuration des métaux est réalisée par des procédés damascènes comprenant des étapes de dépôt d'une couche isolantes suivi par une gravure de la couche d'isolant puis le dépôt du métal dans la cavité créée, et finalement une planarisation de type CMP pour retirer le métal excédentaire. Les structures de métaux peuvent aussi être réalisées par usinage ionique.. Les métaux nobles sont moins courants car ils contaminent les structures de type CMOS, à l'exception du cuivre qui est omniprésent, du fait de son utilisation pour la réalisation des niveaux d'interconnexion entre les transistors. La gestion de la contamination par des structures métalliques est réalisée via des étapes de décontamination, et/ou par encapsulation.

L'utilisation d'un procédé de type CMOS pour fabriquer les systèmes hybrides permet un accès à des lignes de production de slilicium et donc à une fabrication présentant un bas coût et de grands volumes.

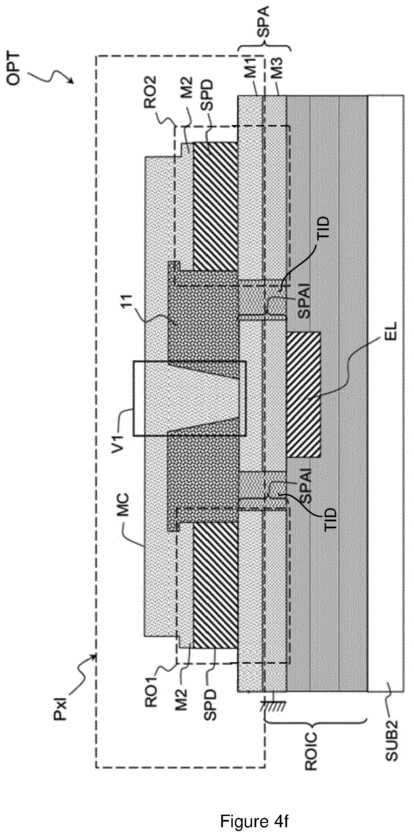

La figure 4f illustre un troisième mode de réalisation de l'hybridation d'un couple de résonateurs optiques d'un même pixel appartenant à un système hybride optoélectronique.

Le troisième mode de réalisation comprend une autre alternative de réalisation de la structure planaire d'assemblage structurée SPAS. En effet, la structure planaire d'assemblage structurée SPAS comprend pour chaque électrode de lecture EL une structure planaire d'assemblage individualisée SPAI isolée électriquement du reste de la structure planaire d'assemblage par un contour en tranchée d'isolation diélectrique TID. La différence avec le deuxième mode de réalisation est la non existence d'une structure planaire d'assemblage individualisée SPAI pour les résonateurs optiques ROᵢ et la continuité de la structure planaire d'assemblage entre les différents résonateurs optiques ROᵢ.

Le troisième mode de réalisation illustre ainsi une structure planaire d'assemblage SPA comprenant uniquement une structure élémentaire d'assemblage individualisée SPAI par électrode de lecture EL. Dans ce cas, pour les résonateurs optiques ROᵢ la structure planaire d'assemblage SPA comprenant la couche métallique réflectrice M1 est commune à tous les résonateurs optiques.

Ce mode de réalisation présente des avantages supplémentaires par rapport au deuxième mode de réalisation. Il assure d'une part une continuité électrique de la masse électrique et d'autre part la structure d'assemblage individualisée de l'électrode de lecture EL permet l'interconnexion entre les résonateurs optiques et les électrodes de lecture associées sans risque de court-circuit avec le plan de masse.

Le procédé de fabrication d'un dispositif optoélectronique selon le troisième mode de réalisation reprend les mêmes étapes du procédé de fabrication du deuxième mode de réalisation tout en tenant en compte de la structure planaire d'assemblage structurée SPAS spécifique au troisième mode de réalisation.

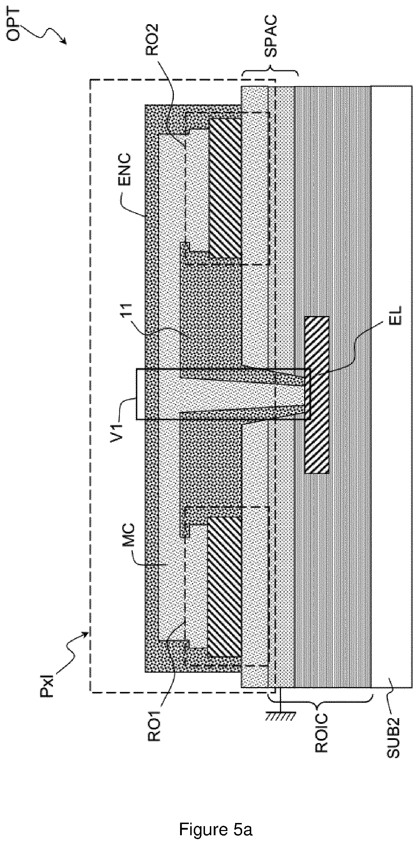

La figure 5a illustre un quatrième mode de réalisation du pixel hybridé selon l'invention compatible avec un procédé de type CMOS.

Le quatrième mode de réalisation du pixel Pxl diffère du premier mode de réalisation par les caractéristiques suivantes :
- pour chaque résonateur optique ROᵢ, la couche métallique supérieure M2 couvre une partie de la surface notée 20A de la structure photo-détectrice SPD et non sa totalité comme dans le premier mode de réalisation.
- le pixel Pxl est encapsulée par une couche d'encapsulation ENC en matériau diélectrique pour éviter la migration du cuivre par exemple contaminant les autres composants du système.

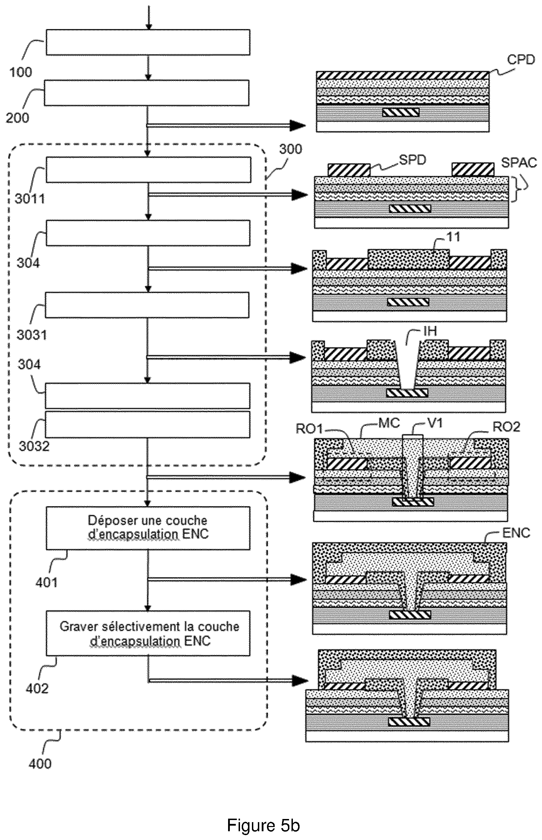

La figure 5b illustre un procédé P3 de fabrication de type CMOS selon l'invention pour réaliser un pixel Pxl hybridé selon le quatrième mode de réalisation.

Les étapes 100 et 200 sont similaires au procédé de fabrication de la figure 4c.

L'étape 300 de fabrication et d'interconnexion d'au moins un pixel Pxl reprend les mêmes étapes technologiques que celles décrites pour le procédé de la figure 4c mais dans un ordre différent et avec des étapes techniques damascènes compatibles avec une ligne de production de CMOS.

Le procédé P3 comprend en outre une étape de réalisation 400 d'une couche d'encapsulation ENC en matériau diélectrique couvrant le pixel Pxl. Ladite étape d'encapsulation comprend les sous-étapes suivantes :
- la sous-étape 401 de dépôt d'une couche d'encapsulation en matériau diélectrique couvrant au moins les secondes couches métalliques M2 et la microstructure de connexion MC.
- ensuite la sous-étape 402 de gravure sélective de la couche en matériau diélectrique préalablement déposée pour garder au moins les parties couvrant la couche métallique supérieure M2 réalisant ainsi une couche d'encapsulation ENC tel que décrit sur la figure 5a.

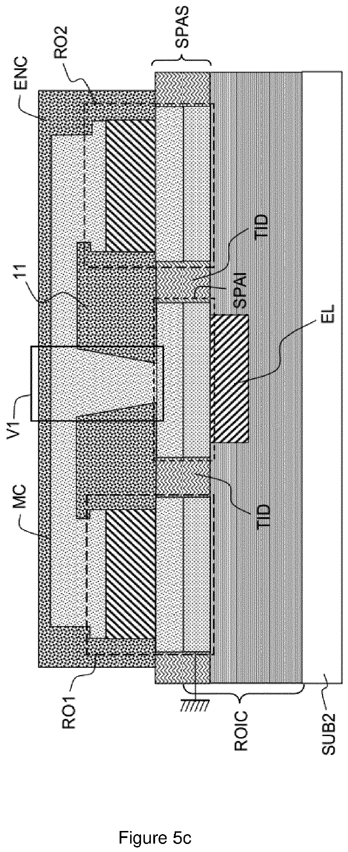

La figure 5c illustre un cinquième mode de réalisation du pixel hybridé selon l'invention compatible avec un procédé de type CMOS. Il s'agit de l'équivalent du quatrième mode de réalisation de la figure 5a mais en reprenant les caractéristiques d'une couche planaire d'assemblage structurée SPAS.

En d'autres termes, le cinquième mode de réalisation du pixel Pxl diffère du second mode de réalisation de la figure 4b par les caractéristiques suivantes :
- pour chaque résonateur optique ROᵢ, la couche métallique supérieure M2 couvre une partie de la surface notée 20A de la structure photo-détectrice SPD et non sa totalité comme dans le premier mode de réalisation.
- le pixel Pxl est encapsulé par une couche d'encapsulation ENC en matériau diélectrique pour éviter la migration du cuivre par exemple contaminant les autres composants du système.

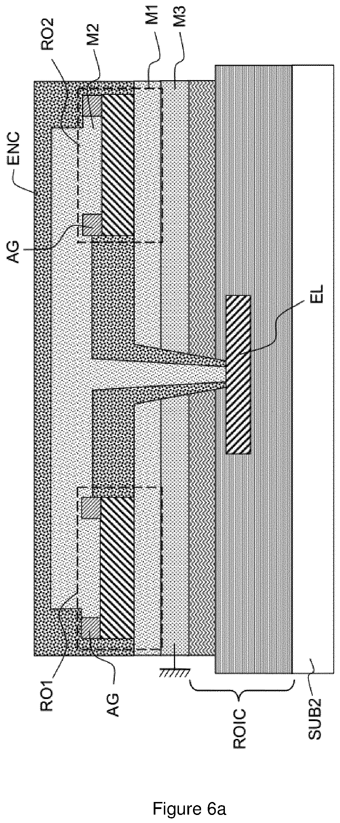

La figure 6a illustre un cinquième mode de réalisation de l'hybridation d'un pixel appartenant à un système hybride optoélectronique permettant d'éviter les problèmes de sur-gravure au niveau de chacune des structures photo détectrices SPD. En effet, Le cinquième mode de réalisation du pixel Pxl diffère du quatrième mode de réalisation par la caractéristique suivante :
- La surface supérieure d'une structure photodetectrice SPD est entourée par un anneau d'arrêt de gravure (pouvant être appelé aussi anneau d'arrêt de polissage) AG réalisé avec un matériau diélectrique. Cette structure d'anneau permet d'arrêter la gravure de la couche électrique de passivation exactement au niveau des surfaces supérieures 20A.

Alternativement, Il est envisageable aussi de couvrir les surfaces latérales d'une structure photo détectrice par une couche d'arrêt de gravure AG.

L'exemple illustré sur la figure 6a reprend la structure d'une couche d'assemblage continue SPAC. Sans perte de généralité, il est possible d'intégrer la solution de l'anneau d'arrêt de gravure dans une structure de pixel selon l'invention présentant une couche planaire d'assemblage structurée SPAS.

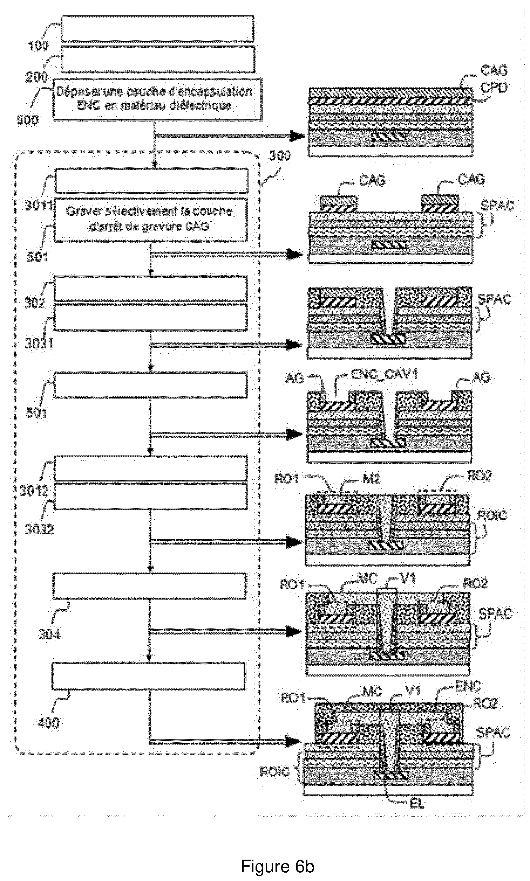

La figure 6b illustre un procédé de fabrication P4 pour réaliser un pixel appartenant à un système hybride optoélectronique selon le cinquième mode de réalisation.

Le procédé de fabrication P4 est un « procédé CMOS ». Les étapes d'assemblage 100 et de détachement 200 sont similaires aux procédés P1 et P2 décrits précédemment.

Dans le procédé P4, la troisième étape 500 consiste à déposer une couche d'arrêt de gravure CAG (pouvant être appelée aussi couche d'arrêt de polissage) sur la couche photo détectrice CPD préalablement à l'étape de réalisation et de connexion 300 d'un pixel Pxl à l'électrode enterrée associée EL.

L'étape 300 de réalisation et de connexion du pixel Pxl comprend une succession de sous-étapes compatibles avec un procédé de type « CMOS ».

La première étape 3011 de réalisation des structures photodétectrices SPD est similaire à celle de P3 décrite précédemment.

La deuxième étape 501 consiste à graver sélectivement la couche d'arrêt de gravure CAG pour garder uniquement les parties reposant sur la surface supérieure 20A de chaque structure photo détectrice SPD.

La troisième étape 302 consiste à réaliser le support 11 suivie d'une quatrième étape 3031 de réalisation des trous d'interconnexion **IH** de manière similaire au procédé P3.

La quatrième étape 501 consiste à réitérer une gravure sélective de ce qui reste de la couche d'arrêt de gravure CAG pour réaliser sur chaque structure photo détectrice SPD un anneau d'arrêt de gravure AG (ou anneau d'arrêt de polissage) centré sur la surface 20A.

La cinquième étape de dépôt métallique réalise simultanément le remplissage 3032 du trou d'interconnexion IH pour former le via V1 et le remplissage de la cavité intérieure des anneaux d'arrêt de gravure AG pour former 3012 les secondes couches supérieures M2 de chaque résonateur optique ROᵢ.

La sixième étape 304 consiste à déposer une couche de matériau conducteur sur le support 11 pour connecter les résonateurs optiques ROᵢ. entre eux.

La dernière étape 400 est une étape d'encapsulation du pixel obtenu similaire à celle du procédé de la figure 6b.

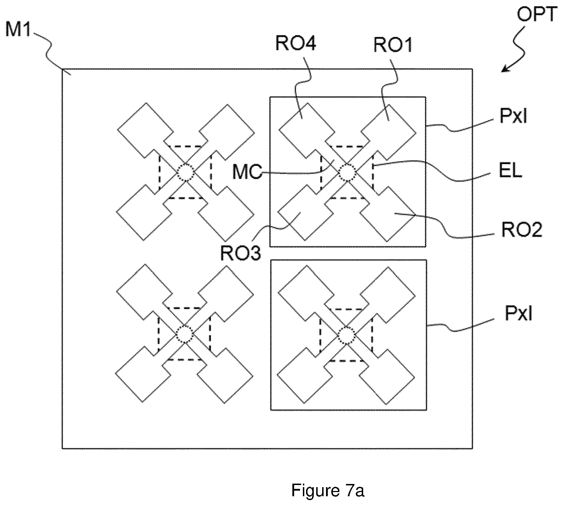

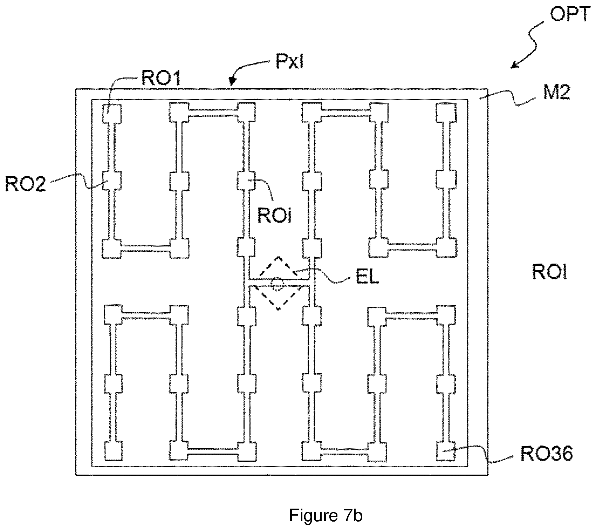

Les figures 7a et 7b illustrent des modes de réalisation alternatifs d'un dispositif optoélectronique OPT comprenant au moins un pixel Pxl. Sur la figure 7a, on illustre 4 pixels tels que chacun comprend 4 résonateurs optiques. Les quatre résonateurs sont connectés via une microstructure de connexion sous forme d'étoile réalisée par le procédé de fabrication selon l'invention. La figure 7b illustre un exemple de dispositif optoélectronique comprenant un seul pixel constitué de 36 résonateurs optiques connectés entre eux via une microstructure réalisé selon l'invention.

Ainsi, l'architecture de pixels selon l'invention basés sur les résonateurs optiques interconnectés et intégrés avec des circuits de lecture selon l'invention présente une nouvelle solution pour la réalisation des capteurs d'images matriciels présentant les avantages techniques suivants :
∘ une architecture de matrice de pixels compacte permettant l'obtention d'une haute résolution.
∘ un système global à volume réduit par rapport aux imageurs de l'état de l'art grâce à l'assemblage direct entre partie optique et partie électrique.
∘ une performance optique améliorée mettant en œuvre les avantages des résonateurs optiques.
∘ une réduction du bruit d'obscurité grâce à la limitation de la surface des zones photodétectrices en matériaux semi-conducteurs.

En guise de conclusion, l'invention décrite permet de réaliser l'hybridation d'un système optoélectronique ayant au moins un pixel comprenant une pluralité de résonateurs optiques de type MIM. La pixellisation et l'interconnexion d'un pixel est réalisée au moyen d'un via de connexion pour connecter les résonateurs optiques appartenant au pixel à l'électrode de lecture enterrée appartenant au circuit de lecture ROIC. Plusieurs modes de réalisation de la structure d'un pixel selon l'invention ont été décrites à titre indicatif sans perte de généralité. L'invention décrite permet en outre de réaliser un procédé de fabrication pour chaque mode de réalisation. Des procédés selon l'invention sont compatibles avec une ligne de production de type « procédé III-V ». D'autres procédés selon l'invention sont compatibles avec une ligne de production de type « procédé CMOS ».

## Revendications

1. Dispositif optoélectronique (OPT) comprenant :
▪ au moins un pixel (Pxl), un pixel comprenant :
∘ une pluralité de résonateurs optiques (RO₁, RO₂), chaque résonateur optique comprenant une structure photo-détectrice (SPD) confinée entre une première couche métallique, réflectrice, (M1) et une seconde couche métallique (M2) ;
∘ et une microstructure de connexion (MC) disposée sur un support (11) en matériau diélectrique et configurée pour connecter électriquement entre elles les secondes couches métalliques (M2) des résonateurs optiques (RO₁, RO₂) appartenant au même pixel (Pxl) ;
▪ un circuit intégré de lecture (ROIC) disposé sur un substrat (Sub2) et assemblé audit pixel ; le circuit de lecture comprenant une électrode de lecture (EL) enterrée associée audit pixel (Pxl) et une couche externe métallique ou diélectrique (M3, D2) ;
l'ensemble comprenant au moins la première couche métallique (M1) et la couche externe (M3) du circuit intégré de lecture étant dénommé structure planaire d'assemblage (SPA) ;
les secondes couches métalliques (M2) des résonateurs (RO₁, RO₂) d'un pixel (Pxl) étant connectées à l'électrode de lecture (EL) associée au moyen d'un via métallique (V1) connecté à la microstructure de connexion (MC) et traversant le support (11).

2. Dispositif optoélectronique (OPT) selon la revendication 1 dans lequel au moins une dimension d'un résonateur (ROᵢ), choisie parmi largeur, longueur, est comprise dans l'intervalle [λ/2n - 50% ; λ/2n + 50%] avec :
λ longueur d'onde incidente
n indice de réfraction effectif de la structure photo-détectrice (SPD)

3. Dispositif optoélectronique (OPT) selon l'une quelconque des revendications précédentes dans lequel la hauteur de la structure photo-détectrice (SPD) est comprise dans l'intervalle [λ/4n - 50% ; λ/2n + 50%] avec :
λ longueur d'onde incidente
n indice de réfraction effectif de la structure photo-détectrice (SPD).

4. Dispositif optoélectronique (OPT) selon l'une quelconque des revendications précédentes dans lequel la distance entre deux pixels (Pxl) adjacents est supérieure ou égale à la longueur d'onde absorbée par un résonateur optique (RO₁, RO₂) divisée par le double de l'indice de réfraction effectif de la structure photo-détectrice (SPD).

5. Dispositif optoélectronique (OPT) selon l'une quelconque des revendications précédentes dans lequel le via métallique (V1) est isolé électriquement des couches métalliques réflectrices (M1) des résonateurs (RO₁, RO₂) dudit pixel (Pxl).

6. Dispositif optoélectronique (OPT) selon l'une quelconque des revendications précédentes dans lequel la seconde couche métallique (M2) couvre la totalité de la surface (20A) de la structure photo-détectrice (SPD).

7. Dispositif optoélectronique (OPT) selon l'une quelconque des revendications 1 à 5 dans lequel la seconde couche métallique (M2) couvre une partie de la surface (20A) de la structure photo-détectrice (SPD) ; la seconde couche métallique (M2) étant intégralement couverte par une couche d'encapsulation en matériau diélectrique (ENC).

8. Dispositif optoélectronique (OPT) selon la revendication 7 comprenant en outre un anneau d'arrêt de gravure (AG) en un matériau diélectrique disposé sur la surface (20A) de la structure photo-détectrice (SPD).

9. Dispositif optoélectronique (OPT) selon l'une quelconque des revendications précédentes dans lequel :
- la couche externe du circuit intégré de lecture (ROIC) est une couche métallique (M3) commune à tous les résonateurs (RO₁, RO₂) dudit au moins un pixel (Pxl), et à tous les pixels (Pxl) le cas échéant, ladite couche externe métallique (M3) étant connectée à la masse électrique.
- la couche métallique réflectrice (M1) est commune à tous les résonateurs (RO₁, RO₂) dudit au moins un pixel (Pxl), et à tous les pixels (Pxl) le cas échéant.
- et le via métallique (V1) traverse ladite structure d'assemblage (SPA) et une partie du circuit intégré de lecture (ROIC) jusqu'à l'électrode de lecture (EL).

10. Dispositif optoélectronique (OPT) selon l'une quelconque des revendications 1 à 8 dans lequel la structure planaire d'assemblage (SPA) est structurée de manière à former des structures élémentaires d'assemblage (SPAI) individualisées pour chaque électrode (EL) ; lesdites structures élémentaires d'assemblage (SPAI) étant isolées électriquement les unes des autres ;
une structure élémentaire d'assemblage (SPAI) associée à une électrode (EL) d'un pixel (Pxl) étant connectée électriquement à ladite électrode (EL) et au via métallique (V1) dudit pixel (Pxl).

11. Capteur d'image matriciel comprenant un dispositif optoélectronique (OPT) selon l'une quelconque des revendications précédentes.

12. Procédé de fabrication d'un dispositif optoélectronique (OPT), le procédé comprenant les étapes consistant à :
- assembler (100) d'une part une première structure planaire (S1) comprenant un premier substrat (Sub1), un ensemble d'au moins une couche photo-détectrice (CPD) et d'une première couche métallique réflectrice (M1) ;
et d'autre part un circuit intégré de lecture (ROIC) déposé sur un deuxième substrat (Sub2) et comprenant au moins une électrode de lecture enterrée (EL) et une couche externe (M3) métallique ou diélectrique ;
l'ensemble comprenant au moins la première couche métallique (M1) et la couche externe (M3,D2) du circuit intégré de lecture (ROIC) formant une structure planaire d'assemblage (SPA), la structure planaire d'assemblage (SPA) étant soit continue (SPAC), soit structurée (SPAS) et comprenant des structures élémentaires d'assemblage (SPAI) individualisées isolées électriquement entre elles ;
lorsque la structure planaire d'assemblage (SPAC) est continue, l'électrode de lecture enterrée (EL) est isolée électriquement de la structure planaire d'assemblage continue (SPAC) ;
lorsque la structure planaire d'assemblage (SPAS) est structurée, l'électrode de lecture enterrée (EL) est connectée électriquement à une structure élémentaire d'assemblage :
- détacher (200) le premier substrat (Sub1) ;
- réaliser (300) au moins un pixel (Pxl) associé à une électrode enterrée (EL) comprenant les sous-étapes de :
∘ réaliser (301) une pluralité de résonateurs optiques (ROᵢ) en :
• Gravant (3011) sélectivement chacune des couches dudit ensemble d'au moins une couche photo-détectrice (CPD) pour réaliser une pluralité de structures photo-détectrices (SPD) ;
• Déposant (3012) une seconde couche métallique (M2) sur chaque structure photo-détectrice (SPD) ;
lorsque la structure planaire d'assemblage (SPAS) est structurée, la structure photo-détectrice (SPD) est localisée en regard d'une structure élémentaire d'assemblage (SPAI) individualisée.
∘ réaliser (302) un support (11) en matériau diélectrique entre les résonateurs et connecter (304) lesdits résonateurs optiques (ROᵢ) entre eux-mêmes au moyen d'une microstructure de connexion (MC) disposée sur ledit support (11) ;
∘ réaliser (303) un via métallique (V1) traversant le support (11) de manière à connecter les secondes couches métalliques (M2) des résonateurs à l'électrode enterrée associée (EL) via la microstructure de connexion (MC).

13. Procédé de fabrication d'un dispositif optoélectronique (OPT) selon la revendication 12 dans lequel lorsque la structure planaire d'assemblage (SPAC) est continue, l'étape (303) de réalisation du via métallique (V1) comprend les sous-étapes de :
• graver (3031) un trou d'interconnexion (IH) traversant la structure d'assemblage (SPAC) jusqu'à l'électrode enterrée (EL) ;
• remplir (3032) le trou d'interconnexion (IH) par un matériau conducteur pour connecter électriquement les secondes couches métalliques (M2) à l'électrode enterrée (EL) ;
L'étape de réalisation du support (11) étant tel que ledit support (11) ne couvre pas le trou d'interconnexion (IH).

14. Procédé de fabrication d'un dispositif optoélectronique (OPT) selon la revendication 12 dans lequel lorsque la structure planaire d'assemblage (SPAS) est structurée, l'étape (303) de réalisation du via métallique (V1) comprend les sous-étapes de :
• graver (3031') un trou d'interconnexion (IH) traversant le support (11) jusqu'à la structure élémentaire d'assemblage (SPAI) connectée à l'électrode enterrée (EL) ;
• remplir (3032) le trou d'interconnexion (IH) par un matériau conducteur pour connecter électriquement les secondes couches métalliques (M2) à la structure élémentaire d'assemblage (SPAI) connectée à l'électrode enterrée (EL).

15. Procédé de fabrication d'un dispositif optoélectronique (OPT) selon l'une quelconque des revendications 12 à 14 comprenant en outre une étape (400) d'encapsulation du pixel (Pxl) comprenant les sous-étapes suivantes :
- déposer (401) une couche d'encapsulation en matériau diélectrique (ENC) couvrant les secondes couches métalliques (M2) et la microstructure de connexion (MC).
- graver sélectivement (402) la couche d'encapsulation (ENC) pour garder au moins les parties couvrant la première couche métallique (M1) et la microstructure de connexion (MC).

16. Procédé de fabrication d'un dispositif optoélectronique (OPT) selon la revendication 15 comprenant :
- une étape de dépôt (500) d'une couche d'arrêt de gravure (CAG) sur une couche externe dudit ensemble d'au moins une couche photo-détectrice (CPD) préalablement à l'étape de réalisation (300) d'au moins un pixel (Pxl) associé à une électrode enterrée (EL) ;
et dans lequel l'étape de réalisation (300) d'au moins un pixel (Pxl) comprend en outre les sous-étapes suivantes :
▪ graver sélectivement (501) la couche d'arrêt de gravure (CAG) pour réaliser pour chaque résonateur un anneau d'arrêt de gravure (AG) disposé sur une partie de la surface de la structure photo-détectrice (SPD) servant à contenir la première couche métallique (M1).

17. Procédé de fabrication d'un dispositif optoélectronique (OPT) selon l'une des revendications 12 ou 14 dans lequel le matériau conducteur déposé pour la réalisation de la seconde couche métallique (M2) et du via métallique (V1) est l'or ou le titane ou le platine.

18. Procédé de fabrication d'un dispositif optoélectronique (OPT) selon l'une des revendications 15 ou 16 dans lequel le matériau conducteur déposé pour la réalisation de la seconde couche métallique (M2) et du via métallique (V1) est le cuivre ou l'aluminium ou le tungstène.

19. Procédé selon l'une des revendications 12 à 18 dans lequel l'étape (3001) de réalisation d'une pluralité de résonateurs optiques (ROᵢ) et l'étape (3003) de réalisation du via métallique (V1) s'effectuent par lithographie puis gravure, la technologie de lithographie étant choisie parmi : par faisceau d'électrons ; par nano-impression ; par lithographie optique, et la technologie de gravure étant choisie parmi la gravure ionique, gravure chimique ou plasma.

## Patentansprüche

1. Optoelektronische Vorrichtung (OPT), Folgendes umfassend:
▪ mindestens ein Pixel (Pxl), wobei ein Pixel Folgendes umfasst:
∘ eine Vielzahl von optischen Resonatoren (RO₁, RO₂), wobei jeder optische Resonator eine Photodetektorstruktur (SPD) umfasst, die zwischen einer ersten reflektierenden metallischen Schicht (M1) und einer zweiten metallischen Schicht (M2) eingeschlossen ist;
∘ und eine Verbindungsmikrostruktur (MC), die auf einem Träger (11) aus dielektrischem Material angeordnet und so konfiguriert ist, dass sie die zweiten metallischen Schichten (M2) der optischen Resonatoren (RO₁, RO₂), die zu demselben Pixel (Pxl) gehören, elektrisch miteinander verbindet;
▪ eine integrierte Ausleseschaltung (ROIC), die auf einem Substrat (Sub2) angeordnet und mit dem Pixel zusammengebaut ist; wobei die Ausleseschaltung eine vergrabene Ausleseelektrode (EL), die dem Pixel (Pxl) zugeordnet ist, und eine metallische oder dielektrische Außenschicht (M3, D2) umfasst;
wobei die Anordnung, die mindestens die erste metallische Schicht (M1) und die Außenschicht (M3) der integrierten Ausleseschaltung umfasst, als planare Anordnungsstruktur (SPA) bezeichnet wird;
wobei die zweiten metallischen Schichten (M2) der Resonatoren (RO₁, RO₂) eines Pixels (Pxl) mit der zugeordneten Ausleseelektrode (EL) mittels einer metallischen Durchkontaktierung (V1) verbunden sind, die mit der Verbindungsmikrostruktur (MC) verbunden ist und durch den Träger (11) hindurchgeht.

2. Optoelektronische Vorrichtung (OPT) nach Anspruch 1, wobei mindestens eine Abmessung eines Resonators (ROᵢ), ausgewählt aus Breite, Länge, in dem Intervall [λ/2n - 50 %; λ/2n + 50 %] liegt, worin:
λ eine einfallende Wellenlänge ist
n ein effektiver Brechungsindex der Photodetektorstruktur (SPD) ist.

3. Optoelektronische Vorrichtung (OPT) nach einem der vorhergehenden Ansprüche, wobei die Höhe der Photodetektorstruktur (SPD) in dem Intervall [λ/4n - 50 %; λ/2n + 50 %] liegt, worin:
λ eine einfallende Wellenlänge ist
n ein effektiver Brechungsindex der Photodetektorstruktur (SPD) ist.

4. Optoelektronische Vorrichtung (OPT) nach einem der vorhergehenden Ansprüche, wobei der Abstand zwischen zwei angrenzenden Pixeln (Pxl) größer als die oder gleich der Wellenlänge ist, die von einem optischen Resonator (RO₁, RO₂) absorbiert ist, geteilt durch das Doppelte des effektiven Brechungsindex der Photodetektorstruktur (SPD).

5. Optoelektronische Vorrichtung (OPT) nach einem der vorhergehenden Ansprüche, wobei die metallische Durchkontaktierung (V1) elektrisch von den reflektierenden metallischen Schichten (M1) der Resonatoren (RO₁, RO₂) des Pixels (Pxl) isoliert ist.

6. Optoelektronische Vorrichtung (OPT) nach einem der vorhergehenden Ansprüche, wobei die zweite metallische Schicht (M2) die gesamte Oberfläche (20A) der Photodetektorstruktur (SPD) bedeckt.

7. Optoelektronische Vorrichtung (OPT) nach einem der Ansprüche 1 bis 5, wobei die zweite metallische Schicht (M2) einen Teil der Oberfläche (20A) der Photodetektorstruktur (SPD) bedeckt; wobei die zweite metallische Schicht (M2) vollständig von einer Einkapselungsschicht aus dielektrischem Material (ENC) bedeckt ist.

8. Optoelektronische Vorrichtung (OPT) nach Anspruch 7, ferner umfassend einen Ätzstoppring (AG) aus einem dielektrischen Material, der auf der Oberfläche (20A) der Photodetektorstruktur (SPD) angeordnet ist.

9. Optoelektronische Vorrichtung (OPT) nach einem der vorhergehenden Ansprüche, wobei:
- die Außenschicht der integrierten Ausleseschaltung (ROIC) eine metallische Schicht (M3) ist, die allen Resonatoren (RO₁, RO₂) des mindestens einen Pixels (Pxl), und gegebenenfalls allen Pixeln (Pxl), gemeinsam ist, wobei die metallische Außenschicht (M3) mit der elektrischen Masse verbunden ist.
- die reflektierende metallische Schicht (M1) allen Resonatoren (RO₁, RO₂) des mindestens einen Pixels (Pxl), und gegebenenfalls allen Pixeln (Pxl), gemeinsam ist.
- und die metallische Durchkontaktierung (V1) durch die Anordnungsstruktur (SPA) und einen Teil der integrierten Ausleseschaltung (ROIC) bis zur Ausleseelektrode (EL) hindurchgeht.

10. Optoelektronische Vorrichtung (OPT) nach einem der Ansprüche 1 bis 8, wobei die planare Anordnungsstruktur (SPA) so strukturiert ist, dass sie individualisierte elementare Anordnungsstrukturen (SPAI) für jede Elektrode (EL) bildet; wobei die elementaren Anordnungsstrukturen (SPAI) elektrisch voneinander isoliert sind;
wobei eine elementare Anordnungsstruktur (SPAI), die einer Elektrode (EL) eines Pixels (Pxl) zugeordnet ist, elektrisch mit der Elektrode (EL) und der metallischen Durchkontaktierung (V1) des Pixels (Pxl) verbunden ist.

11. Matrixbildsensor, umfassend eine optoelektronische Vorrichtung (OPT) nach einem der vorhergehenden Ansprüche.

12. Verfahren zum Herstellen einer optoelektronischen Vorrichtung (OPT), wobei das Verfahren die folgenden Schritte umfasst:
- Zusammenbauen (100), einerseits, einer ersten planaren Struktur (S1), die ein erstes Substrat (Sub1), eine Anordnung aus mindestens einer Photodetektorschicht (CPD) und einer ersten reflektierenden metallischen Schicht (M1) umfasst;
und andererseits, einer integrierten Ausleseschaltung (ROIC), die auf einem zweiten Substrat (Sub2) abgelagert ist und mindestens eine vergrabene Ausleseelektrode (EL) und eine metallische oder dielektrische Außenschicht (M3) umfasst;
wobei die Anordnung, die mindestens die erste metallische Schicht (M1) und die Außenschicht (M3, D2) der integrierten Ausleseschaltung (ROIC) umfasst, eine planare Anordnungsstruktur (SPA) bildet, wobei die planare Anordnungsstruktur (SPA) entweder kontinuierlich (SPAC) oder strukturiert (SPAS) ist und individualisierte elementare Anordnungsstrukturen (SPAI) umfasst, die voneinander elektrisch isoliert sind;
wenn die planare Anordnungsstruktur (SPAC) kontinuierlich ist, ist die vergrabene Ausleseelektrode (EL) von der kontinuierlichen planaren Anordnungsstruktur (SPAC) elektrisch isoliert;
wenn die planare Anordnungsstruktur (SPAS) strukturiert ist, ist die vergrabene Ausleseelektrode (EL) elektrisch mit einer elementaren Anordnungsstruktur verbunden:
- Lösen (200) des ersten Substrats (Sub1);
- Fertigen (300) mindestens eines Pixels (Pxl), das mit einer vergrabenen Elektrode (EL) verbunden ist, umfassend die folgenden Teilschritte:
∘ Fertigen (301) einer Vielzahl von optischen Resonatoren (ROᵢ) durch Folgendes:
• selektives Ätzen (3011) jeder der Schichten der Anordnung von mindestens einer Photodetektorschicht (CPD), um eine Vielzahl von Photodetektorstrukturen (SPD) zu fertigen;
• Ablagern (3012) einer zweiten metallischen Schicht (M2) auf jeder Photodetektorstruktur (SPD);
wenn die planare Anordnungsstruktur (SPAS) strukturiert ist, befindet sich die Photodetektorstruktur (SPD) gegenüber einer individualisierten elementaren Anordnungsstruktur (SPAI).
∘ Fertigen (302) eines Trägers (11) aus dielektrischem Material zwischen den Resonatoren und Verbinden (304) der optischen Resonatoren (ROᵢ) miteinander mittels einer Verbindungsmikrostruktur (MC), die auf dem Träger (11) angeordnet ist;
∘ Fertigen (303) einer metallischen Durchkontaktierung (V1), die durch den Träger (11) hindurchgeht, sodass die zweiten metallischen Schichten (M2) der Resonatoren mit der zugeordneten vergrabenen Elektrode (EL) über die Verbindungsmikrostruktur (MC) verbunden werden.

13. Verfahren zum Herstellen einer optoelektronischen Vorrichtung (OPT) nach Anspruch 12, wobei, wenn die planare Anordnungsstruktur (SPAC) kontinuierlich ist, der Schritt (303) des Fertigens der metallischen Durchkontaktierung (V1) die folgenden Teilschritte umfasst:
• Ätzen (3031) eines Durchgangslochs (IH), das durch die Anordnungsstruktur (SPAC) bis zur vergrabenen Elektrode (EL) hindurchgeht;
• Füllen (3032) des Durchgangslochs (IH) mit einem leitfähigen Material, um die zweiten metallischen Schichten (M2) elektrisch mit der vergrabenen Elektrode (EL) zu verbinden;
wobei der Schritt des Fertigens des Trägers (11) derart ist, dass der Träger (11) das Durchgangsloch (IH) nicht bedeckt.

14. Verfahren zum Herstellen einer optoelektronischen Vorrichtung (OPT) nach Anspruch 12, wobei, wenn die planare Anordnungsstruktur (SPAS) strukturiert ist, der Schritt (303) des Fertigens der metallischen Durchkontaktierung (V1) die folgenden Teilschritte umfasst:
• Ätzen (3031') eines Durchgangslochs (IH), das durch den Träger (11) bis zu der elementaren Anordnungsstruktur (SPAI) hindurchgeht, die mit der vergrabenen Elektrode (EL) verbunden ist;
• Füllen (3032) des Durchgangslochs (IH) mit einem leitfähigen Material, um die zweiten metallischen Schichten (M2) mit der elementaren Anordnungsstruktur (SPAI), die mit der vergrabenen Elektrode (EL) verbunden ist, elektrisch zu verbinden.

15. Verfahren zum Herstellen einer optoelektronischen Vorrichtung (OPT) nach einem der Ansprüche 12 bis 14, ferner umfassend einen Schritt (400) des Einkapselns des Pixels (Pxl), der die folgenden Teilschritte umfasst:
- Ablagern (401) einer Einkapselungsschicht aus dielektrischem Material (ENC), welche die zweiten metallischen Schichten (M2) und die Verbindungsmikrostruktur (MC) bedeckt.
- selektives Ätzen (402) der Einkapselungsschicht (ENC), um mindestens die Teile, welche die erste metallische Schicht (M1) und die Verbindungsmikrostruktur (MC) abdecken, zu behalten.

16. Verfahren zum Herstellen einer optoelektronischen Vorrichtung (OPT) nach Anspruch 15, Folgendes umfassend:
- einen Schritt des Ablagerns (500) einer Ätzstoppschicht (CAG) auf einer Außenschicht der Anordnung aus mindestens einer Photodetektorschicht (CPD) vor dem Schritt des Fertigens (300) mindestens eines Pixels (Pxl), das mit einer vergrabenen Elektrode (EL) verbunden ist;
und wobei der Schritt (300) des Fertigens mindestens eines Pixels (Pxl) ferner die folgenden Teilschritte umfasst:
▪ selektives Ätzen (501) der Ätzstoppschicht (CAG), um für jeden Resonator einen Ätzstoppring (AG) zu fertigen, der auf einem Teil der Oberfläche der Photodetektorstruktur (SPD) angeordnet ist, die dazu dient, die erste metallische Schicht (M1) zu enthalten.

17. Verfahren zum Herstellen einer optoelektronischen Vorrichtung (OPT) nach einem der Ansprüche 12 oder 14, wobei das zum Fertigen der zweiten metallischen Schicht (M2) und der metallischen Durchkontaktierung (V1) abgelagerte leitfähige Material Gold oder Titan oder Platin ist.

18. Verfahren zum Herstellen einer optoelektronischen Vorrichtung (OPT) nach einem der Ansprüche 15 oder 16, wobei das zum Fertigen der zweiten metallischen Schicht (M2) und der metallischen Durchkontaktierung (V1) abgelagerte leitfähige Material Kupfer oder Aluminium oder Wolfram ist.

19. Verfahren nach einem der Ansprüche 12 bis 18, wobei der Schritt (3001) des Fertigens einer Vielzahl von optischen Resonatoren (ROᵢ) und der Schritt (3003) des Fertigens der metallischen Durchkontaktierung (V1) durch Lithografie und anschließendes Ätzen durchgeführt wird, wobei die Lithografietechnologie ausgewählt ist aus: Elektronenstrahl; Nanodrucken; optischer Lithografie, und die Ätztechnologie ausgewählt ist aus Ionenätzen, chemischem Ätzen oder Plasmaätzen.

## Claims

1. An optoelectronic device (OPT) comprising:
▪ at least one pixel (Pxl), a pixel comprising:
∘ a plurality of optical resonators (RO₁, RO₂), each optical resonator comprising a photodetecting structure (SPD) confined between a first, reflective, metal layer (M1) and a second metal layer (M2);
∘ and a connection microstructure (MC) that is arranged on a support (11) made of dielectric material and is configured to electrically connect the second metal layers (M2) of the optical resonators (RO₁, RO₂) belonging to the same pixel (Pxl);
▪ a readout integrated circuit (ROIC) arranged on a substrate (Sub2) and assembled with said pixel; the readout circuit comprising a buried readout electrode (EL) associated with said pixel (Pxl) and a metal or dielectric outer layer (M3, D2);
the assembly comprising at least the first metal layer (M1) and the outer layer (M3) of the readout integrated circuit being referred to as planar assembly structure (SPA);
the second metal layers (M2) of the resonators (RO₁, RO₂) of a pixel (Pxl) being connected to the associated readout electrode (EL) by way of a metal via (V1) connected to the connection microstructure (MC) and passing through the support (11).

2. The optoelectronic device (OPT) according to claim 1, wherein at least one dimension of a resonator (ROᵢ), chosen from among width, length, is within the interval [λ/2n - 50 %; λ/2n + 50 %], where:
λ is an incident wavelength,
n is an effective refractive index of the photodetecting structure (SPD).

3. The optoelectronic device (OPT) according to any one of the preceding claims, wherein the height of the photodetecting structure (SPD) is within the interval [λ/4n - 50 %; λ/2n + 50 %], where:
λ is an incident wavelength,
n is an effective refractive index of the photodetecting structure (SPD).

4. The optoelectronic device (OPT) according to any one of the preceding claims, wherein the distance between two adjacent pixels (Pxl) is greater than or equal to the wavelength absorbed by an optical resonator (RO₁, RO₂) divided by twice the effective refractive index of the photodetecting structure (SPD).

5. The optoelectronic device (OPT) according to any one of the preceding claims, wherein the metal via (V1) is electrically isolated from the reflective metal layers (M1) of the resonators (RO₁, RO₂) of said pixel (Pxl).

6. The optoelectronic device (OPT) according to any one of the preceding claims, wherein the second metal layer (M2) covers the entire surface (20A) of the photodetecting structure (SPD).

7. The optoelectronic device (OPT) according to any one of claims 1 to 5, wherein the second metal layer (M2) covers part of the surface (20A) of the photodetecting structure (SPD); the second metal layer (M2) being fully covered by an encapsulating layer made of dielectric material (ENC).

8. The optoelectronic device (OPT) according to claim 7, further comprising an etch stop ring (AG) made of a dielectric material arranged on the surface (20A) of the photodetecting structure (SPD).

9. The optoelectronic device (OPT) according to any one of the preceding claims, wherein:
- the outer layer of the readout integrated circuit (ROIC) is a metal layer (M3) common to all of the resonators (RO₁, RO₂) of said at least one pixel (Pxl), and to all of the pixels (Pxl) where applicable, said metal outer layer (M3) being connected to electrical ground.
- the reflective metal layer (M1) is common to all of the resonators (RO₁, RO₂) of said at least one pixel (Pxl), and to all of the pixels (Pxl) where applicable.
- and the metal via (V1) passes through said assembly structure (SPA) and part of the readout integrated circuit (ROIC) up to the readout electrode (EL).

10. The optoelectronic device (OPT) according to any one of claims 1 to 8, wherein the planar assembly structure (SPA) is structured so as to form individualised elementary assembly structures (SPAI) for each electrode (EL); said elementary assembly structures (SPAI) being electrically isolated from one another;
an elementary assembly structure (SPAI) associated with an electrode (EL) of a pixel (Pxl) being electrically connected to said electrode (EL) and to the metal via (V1) of said pixel (Pxl).

11. A matrix image sensor comprising an optoelectronic device (OPT) according to any one of the preceding claims.

12. A method for manufacturing an optoelectronic device (OPT), the method comprising the steps of:
- assembling (100) a first planar structure (S1) comprising a first substrate (Sub1), an assembly of at least one photodetecting layer (CPD) and a first reflective metal layer (M1), on the one hand;
and a readout integrated circuit (ROIC) deposited on a second substrate (Sub2) and comprising at least one buried readout electrode (EL) and a metal or dielectric outer layer (M3), on the other hand;
the assembly comprising at least the first metal layer (M1) and the outer layer (M3, D2) of the readout integrated circuit (ROIC) forming a planar assembly structure (SPA), the planar assembly structure (SPA) being either continuous (SPAC) or structured (SPAS) and comprising individualised elementary assembly structures (SPAI) that are electrically isolated from one another;
when the planar assembly structure (SPAC) is continuous, the buried readout electrode (EL) is electrically isolated from the continuous planar assembly structure (SPAC);
when the planar assembly structure (SPAS) is structured, the buried readout electrode (EL) is electrically connected to an elementary assembly structure:
- detaching (200) the first substrate (Sub1);
- producing (300) at least one pixel (Pxl) associated with a buried electrode (EL), comprising the sub-steps of:
∘ producing (301) a plurality of optical resonators (ROᵢ) by:
• selectively etching (3011) each of the layers of said assembly of at least one photodetecting layer (CPD) to produce a plurality of photodetecting structures (SPD);
• depositing (3012) a second metal layer (M2) on each photodetecting structure (SPD);
when the planar assembly structure (SPAS) is structured, the photodetecting structure (SPD) is located facing an individualised elementary assembly structure (SPAI),
∘ producing (302) a support (11) made of dielectric material between the resonators and connecting (304) said optical resonators (ROᵢ) to one another by way of a connection microstructure (MC) arranged on said support (11);
∘ producing (303) a metal via (V1) passing through the support (11) so as to connect the second metal layers (M2) of the resonators to the associated buried electrode (EL) via the connection microstructure (MC).

13. The method for manufacturing an optoelectronic device (OPT) according to claim 12, wherein, when the planar assembly structure (SPAC) is continuous, the step (303) of producing the metal via (V1) comprises the sub-steps of:
• etching (3031) a via hole (IH) passing through the assembly structure (SPAC) up to the buried electrode (EL);
• filling (3032) the via hole (IH) with a conductive material to electrically connect the second metal layers (M2) to the buried electrode (EL);
the step of producing the support (11) being such that said support (11) does not cover the via hole (IH).

14. The method for manufacturing an optoelectronic device (OPT) according to claim 12, wherein, when the planar assembly structure (SPAS) is structured, the step (303) of producing the metal via (V1) comprises the sub-steps of:
• etching (3031') a via hole (IH) passing through the support (11) up to the elementary assembly structure (SPAI) connected to the buried electrode (EL);
• filling (3032) the via hole (IH) with a conductive material to electrically connect the second metal layers (M2) to the elementary assembly structure (SPAI) connected to the buried electrode (EL).

15. The method for manufacturing an optoelectronic device (OPT) according to any one of claims 12 to 14, further comprising a step (400) of encapsulating the pixel (Pxl), comprising the following sub-steps:
- depositing (401) an encapsulating layer made of dielectric material (ENC) covering the second metal layers (M2) and the connection microstructure (MC),
- selectively etching (402) the encapsulating layer (ENC) to retain at least the parts covering the first metal layer (M1) and the connection microstructure (MC).

16. The method for manufacturing an optoelectronic device (OPT) according to claim 15, comprising:
- a step of depositing (500) an etch stop layer (CAG) on an outer layer of said assembly of at least one photodetecting layer (CPD) prior to the step of producing (300) at least one pixel (Pxl) associated with a buried electrode (EL);
and wherein the step of producing (300) at least one pixel (Pxl) further comprises the following sub-steps:
▪ selectively etching (501) the etch stop layer (CAG) to produce, for each resonator, an etch stop ring (AG) arranged on part of the surface of the photodetecting structure (SPD) for containing the first metal layer (M1).

17. The method for manufacturing an optoelectronic device (OPT) according to one of claim 12 or 14, wherein the conductive material deposited to produce the second metal layer (M2) and the metal via (V1) is gold or titanium or platinum.

18. The method for manufacturing an optoelectronic device (OPT) according to one of claim 15 or 16, wherein the conductive material deposited to produce the second metal layer (M2) and the metal via (V1) is copper or aluminium or tungsten.

19. The method according to one of claims 12 to 18, wherein the step (3001) of producing a plurality of optical resonators (ROᵢ) and the step (3003) of producing the metal via (V1) are carried out by lithography then etching, the lithography technology being chosen from among: by electron beam; by nanoprinting; by optical lithography, and the etching technology being chosen from among ion etching, chemical or plasma etching.
